# EUROPEAN PATENT APPLICATION

(11) **EP 4 491 893 A1**
(43) Date of publication of application: **15.01.2025**
(21) Application number: 23849133.6
(22) Date of filing: 30.06.2023
(51) Int. Cl.: F16C 11/04, F16C 11/12, G09F 9/30

(54) **ROTATION SHAFT MECHANISM AND ELECTRONIC APPARATUS**

(30) Priority: 30.07.2022 CN 202210911441
(71) Applicant: Huawei Technologies Co., Ltd., Shenzhen, Guangdong 518129 (CN)
(72) Inventor: SHI, Tuo, Shenzhen, Guangdong 518129 (CN); ZHAN, Qiang, Shenzhen, Guangdong 518129 (CN)
(74) Representative: Goddar, Heinz J.
(86) International application number: PCT/CN2023/104968
(87) International publication number: WO 2024/027423

(57) **Abstract**

This application discloses a hinge mechanism and an electronic device, to improve structural strength of the hinge mechanism and prolong a service life of the hinge mechanism. The hinge mechanism includes a base, a rotating assembly, and a damping assembly. The rotating assembly includes a first rotating arm and a second rotating arm. The first rotating arm and the second rotating arm are rotatably connected to two sides of the base respectively. One side that is of the first rotating arm and that is close to the base has a first cam surface. One side that is of the second rotating arm and that is close to the base has a second cam surface. The damping assembly includes a transmission member, a first fastening part, and an elastic member. The transmission member is slidably disposed on the base in a first direction. The transmission member is located between the first rotating arm and the second rotating arm. Two sides of the transmission member abut against the first cam surface and the second cam surface respectively. The transmission member is capable of sliding in the first direction when the first rotating arm and the second rotating arm rotate. The first fastening part is fastened on the base. The first fastening part and the transmission member are disposed at an interval in the first direction. The elastic member is limited between the transmission member and the first fastening part.

## Description

### CROSS-REFERENCE TO RELATED APPLICATION

This application claims priority to Chinese Patent Application No. 202210911441.1, filed with the China National Intellectual Property Administration on July 30, 2022 and entitled "HINGE MECHANISM AND ELECTRONIC DEVICE", which is incorporated herein by reference in its entirety.

### TECHNICAL FIELD

This application relates to the field of electronic device technologies, and in particular, to a hinge mechanism and an electronic device.

### BACKGROUND

As a flexible display technology gradually becomes mature, a display manner of electronic devices is driven to greatly change. Mobile phones with a foldable flexible display, tablet computers with a foldable flexible display, wearable electronic devices with a foldable flexible display, and the like are an important evolution direction of intelligent electronic devices in the future.

As an important component for a foldable electronic device to implement a folding function, in addition to changing a folding status of the electronic device, a hinge mechanism may further provide enough damping forces for the entire electronic device in different folding statuses, so that the electronic device has a reliable support force in a process of switching the folding status. However, as the electronic device continuously develops toward lightness and thinness, a size of the hinge mechanism also needs to be correspondingly reduced to match a thin electronic device. As a result, contact stress of a mechanical part that is in the hinge mechanism and that is configured to provide a damping force is increased, and consequently, structural strength and a service life of the hinge mechanism are affected.

### SUMMARY

This application provides a hinge mechanism and an electronic device, to improve structural strength of the hinge mechanism and prolong a service life of the hinge mechanism.

According to a first aspect, this application provides a hinge mechanism. The hinge mechanism may include a base, a rotating assembly, and a damping assembly. The hinge assembly may include a first rotating arm and a second rotating arm. The first rotating arm and the second rotating arm may be rotatably connected to two sides of the base respectively. One side that is of the first rotating arm and that is close to the base has a first cam surface. One side that is of the second rotating arm and that is close to the base has a second cam surface. The damping assembly may include a transmission member, a first fastening part, and an elastic member. An extension direction of a rotation axis of the first rotating arm and the second rotating arm is defined as a first direction. The transmission member may be slidably disposed on the base in the first direction. The transmission member may be located between the first rotating arm and the second rotating arm. Two sides of the transmission member abut against the first cam surface and the second cam surface respectively. The transmission member is capable of sliding in the first direction when the first rotating arm and the second rotating arm rotate. The first fastening arm is fastened on the base. The first fastening part and the transmission member are disposed at an interval in the first direction. The elastic member may be elastically limited between the transmission member and the first fastening part.

In the foregoing solution, the transmission member may convert an elastic force generated by the elastic member in an axial direction (the first direction) of the hinge mechanism into a radial force and transmit the force to the first rotating arm and the second rotating arm. Because the elastic member is disposed in the axial direction of the hinge mechanism, a size of the elastic member is not limited by another component of an electronic device. Therefore, the size of the elastic member may be appropriately increased to provide an enough damping force for the electronic device, so that a limitation on an unfolding and folding force of the electronic device may be avoided. In addition, because axial space of a hinge structure is relatively ample, an axial size of the transmission member may be appropriately increased to increase contact areas between the transmission member and the first rotating arm and between the transmission member and the second rotating arm, to reduce contact stress, so that structural strength of the hinge mechanism can be improved, and a service life of the hinge mechanism can be prolonged.

In some possible implementation solutions, the transmission member may include a first cam and a second cam. The first cam is located on one side close to the first rotating arm. One side of the first cam has a third cam surface abutting against the first cam surface, and the other side of the first cam has a first inclined surface. The second cam is located on one side close to the second rotating arm. One side of the second cam has a fourth cam surface abutting against the second cam surface, and the other side of the second cam has a second inclined surface. The first inclined surface and the second inclined surface are in transmission connection. When the first cam and the second cam slide toward or away from each other with rotation of the first rotating arm and the second rotating arm, at least one of the first cam and the second cam may be pushed to slide in the first direction, so that an extension/retraction status of the elastic member limited between the transmission member and the first fastening part is changed. The elastic member also applies a specific elastic force to the transmission member while the elastic member is deformed. The elastic force may be further transmitted to the first rotating arm and the second rotating arm on the two sides through the first cam and the second cam, and converted into the damping force with which the first rotating arm and the second rotating arm rotate relative to the base, so that the first rotating arm and the second rotating arm can stably rotate under an action of the damping force.

In some possible implementation solutions, the damping assembly may further include a second fastening part. The second fastening part is fastened on the base. The second fastening part abuts against one side that is of the transmission member and that is away from the first fastening part, so that the transmission member is positioned on this side.

In some possible implementation solutions, the damping assembly may further include a sliding part. The sliding part may be slidably disposed on the base in the first direction. The sliding part may abut against one side that is of the transmission member and that faces the first fastening part. In this case, one end of the transmission member may abut against the first fastening part, and the other end of the transmission member may abut against the sliding part. When the transmission member is pushed by the first rotating arm and the second rotating arm on the two sides to slide in the first direction, the sliding part may be driven to slide synchronously, so that the elastic member is compressed by the sliding part.

In some possible implementation solutions, the first inclined surface may be located at one end that is of the first cam and that is close to the second fastening part. The second inclined surface may be located at one end that is of the second cam and that is close to the second fastening part. One side that is of the second fastening part and that faces the transmission member may be provided with a first bump. One side that is of the first bump and that faces the first cam has a third inclined surface, and one side that faces the second cam has a fourth inclined surface. The third inclined surface and the first inclined surface are parallel and abut against each other. The fourth inclined surface and the second inclined surface are parallel and abut against each other. In this way, the third inclined surface and the first inclined surface may form an inclined surface transmission pair, and the fourth inclined surface and the second inclined surface may form an inclined surface transmission pair. Based on these two transmission pairs, both the first cam and the second cam may slide in the first direction. Therefore, the first cam and the second cam may jointly compress the elastic member.

In some possible implementation solutions, one side that is of the first cam and that faces the second cam may have a first recess. One side that is of the second cam and that faces the first cam may have a first protrusion. The first protrusion may be at least partially inserted into the first recess, to guide the first cam and the second cam to slide toward or away from each other. In addition, sliding of the first cam and the second cam in the first direction may further be linked. This improves movement consistency between the first cam and the second cam in the first direction.

Similarly, one side that is of the first cam and that faces the second cam may further have a second protrusion. One side that is of the second cam and that faces the first cam may have a second recess. The second protrusion may be at least partially inserted into the second recess. Fitted insertion of the second protrusion and the second cam may also guide the first cam and the second cam to slide toward or away from each other, and may provide assurance for synchronous sliding of the first cam and the second cam in the first direction.

In some possible implementation solutions, one end that is of the first cam and that is close to the sliding part may further have a fifth inclined surface. One end that is of the second cam and that is close to the sliding part may further have a sixth inclined surface. One side that is of the sliding part and that faces the transmission member may have a second bump. One side that is of the second bump and that faces the first cam may have a seventh inclined surface, and one side that faces the second cam may have an eighth inclined surface. The seventh inclined surface and the fifth inclined surface are parallel and abut against each other. The eighth inclined surface and the sixth inclined surface are parallel and abut against each other. In this way, the seventh inclined surface and the fifth inclined surface may form an inclined surface transmission pair, and the eighth inclined surface and the sixth inclined surface may form an inclined surface transmission pair. Based on these two transmission pairs, acting forces, in the first direction, applied by the first cam and the second cam to the sliding part may be superimposed on each other, and the first cam and the second cam may jointly push the sliding part to slide in the first direction. Therefore, movement reliability of the damping assembly can be effectively improved.

In some other possible implementation solutions, one side that is of the sliding part and that faces the transmission member may alternatively be a plane. In this way, a structure of the sliding part may be simplified, to help reduce overall structural complexity of the damping assembly. In this solution, a plane contact perpendicular to the first direction may be formed between the transmission member and the sliding part, so that when the transmission member slides, the sliding part may be directly driven to slide in the first direction.

In some possible implementation solutions, one end that is of the first cam and that faces the second fastening part may abut against the second fastening part. One end that is of the second cam and that faces the first fastening part may abut against the sliding part. The first inclined surface and the second inclined surface are parallel and abut against each other, to form an inclined surface transmission pair. In this solution, the transmission pair formed by the first inclined surface and the second inclined surface is used to implement a damping function of the first rotating arm and the second rotating arm in a rotation process. A structure of the hinge mechanism is simple, and costs are low.

In some possible implementation solutions, the first inclined surface and the second inclined surface are disposed in parallel. A first rack may be disposed on the first inclined surface. A second rack may be disposed on the second inclined surface. In this case, the transmission member may further include an intermediate gear. The intermediate gear may be disposed between the first inclined surface and the second inclined surface, and is separately engaged with the first rack and the second rack. When the first cam and the second cam slide toward or away from each other, two sides of the intermediate gear roll on the first rack and the second rack respectively. In this way, synchronization of sliding of the first cam and the second cam toward or away from each other may be ensured, to further help improve working reliability of the damping assembly.

In some possible implementation solutions, the damping assembly may further include a guide rod. The guide rod is fastened on the base. The guide rod is disposed in the first direction. The transmission member may be sleeved on the guide rod, to use the guide rod to guide sliding of the transmission member. This improves sliding stability of the transmission member in the first direction.

In some possible implementation solutions, the elastic member may be a spring. In this case, the damping assembly may further include a first pin shaft disposed in the first direction. The spring may be sleeved on the first pin shaft, to avoid a problem such as arching that occurs when the spring is elastically deformed.

In some other possible implementation solutions, the elastic member may alternatively be an elastic piece. There may be a plurality of elastic pieces. The plurality of elastic pieces may be disposed, in a stacked manner, between the first fastening part and the sliding part in the first direction.

Certainly, the elastic member may alternatively be in a form of using both the spring and the elastic piece. For example, there may be two springs. The two springs may be disposed on two sides of the plurality of elastic pieces, to ensure uniformity of a force applied to the sliding part, to further help transmit a balanced damping force action to the first rotating arm and the second rotating arm.

According to a second aspect, this application further provides an electronic device. The electronic device may include a first housing, a second housing, a flexible display, and the hinge mechanism in any possible solution of the first aspect. The first housing and the second housing may be disposed on two opposite sides of the hinge mechanism respectively. The first rotating arm is slidably connected to the first housing. The second rotating arm is slidably connected to the second housing. The flexible display screen may continuously cover the first housing, the second housing, and the hinge mechanism. The flexible display screen is fastened to the first housing and the second housing. The hinge mechanism of the electronic device may provide a stable support force in a process of folding or unfolding the electronic device, so that use reliability of the electronic device is improved.

### BRIEF DESCRIPTION OF DRAWINGS

FIG. 1 is a diagram of a structure of an electronic device according to an embodiment of this application;
FIG. 2 is a diagram of a structure of an electronic device, shown in FIG. 1, in an unfolded state;
FIG. 3 is a schematic exploded view of an electronic device shown in FIG. 2;
FIG. 4 is a schematic exploded view of a structure of a hinge mechanism 1 shown in FIG. 3;
FIG. 5 is a diagram of a partial structure of a hinge mechanism according to a possible embodiment of this application;
FIG. 6 is an exploded view of a partial structure of a hinge mechanism shown in FIG. 5;
FIG. 7 is a diagram of a structure of a first swing arm according to a possible embodiment of this application;
FIG. 8 is a diagram of a partial structure of a hinge mechanism;
FIG. 9 is a diagram of a structure of a first housing fastening bracket according to a possible embodiment of this application;
FIG. 10a is a diagram of a structure of a hinge mechanism in an unfolded state;
FIG. 10b is a diagram of a first cross section according to a possible embodiment;
FIG. 10c is a diagram of a structure of a hinge mechanism in an intermediate state;
FIG. 10d is a diagram of a structure of a hinge mechanism in a folded state;
FIG. 11 is a principle diagram of a mechanism in which a first rotating arm and a first swing arm slide relative to a first housing fastening bracket according to an embodiment of this application;
FIG. 12 is a diagram of a structure of a first support plate according to a possible embodiment of this application;
FIG. 13 is a diagram of a structure in which a first support plate and a second support plate support a flexible display according to a possible embodiment of this application;
FIG. 14 is a diagram of a partial structure of a hinge mechanism in an unfolded state according to an embodiment of this application;
FIG. 15 is a diagram of a partial structure of a hinge mechanism in a folded state according to an embodiment of this application;
FIG. 16 is a schematic exploded view of a structure of a hinge mechanism shown in FIG. 14;
FIG. 17 is a diagram of a structure of a cross section of a hinge mechanism shown in FIG. 14 at A-A;
FIG. 18 is a diagram of a structure of a transmission member shown in FIG. 14;
FIG. 19 is a diagram of a structure of a second fastening part and a sliding part according to an embodiment of this application;
FIG. 20 is a diagram of a structure of a cross section of a hinge mechanism shown in FIG. 14 at B-B;
FIG. 21 is a diagram of a partial structure of another hinge mechanism in an unfolded state according to an embodiment of this application;
FIG. 22 is a diagram of a partial structure of another hinge mechanism in an unfolded state according to an embodiment of this application;
FIG. 23 is a diagram of a partial structure of another hinge mechanism in an unfolded state according to an embodiment of this application;
FIG. 24 is a diagram of a partial structure of another hinge mechanism in an unfolded state according to an embodiment of this application;
FIG. 25 is a diagram of a partial structure of another hinge mechanism in an unfolded state according to an embodiment of this application; and
FIG. 26 is a diagram of a partial structure of another hinge mechanism in an unfolded state according to an embodiment of this application.

### Reference numerals:

1: Hinge mechanism; 11: Main hinge module; 11a: First rotating assembly; 11b: Second rotating assembly; 112: First rotating arm;
1121: First sliding block; 1122: First protruding part; 11221: First cam surface;
113: First swing arm; 1131: First arc-shaped rotating block; 1132: Second sliding block;
114: Cover plate; 1141: First arc-shaped protrusion; 1142: Second arc-shaped protrusion;
115: First housing fastening bracket; 115a: First surface; 115b: Second surface; 1151: First sliding slot; 11511: First slide rail;
1152: Second sliding slot; 11521: Second slide rail; 1153: First rotating slot;
16: Base; 163: First arc-shaped groove; 164: Second arc-shaped groove;
17: Damping assembly; 171: Transmission member; 1711: First cam; 17111: Third cam surface; 17112: First inclined surface;
171121: First rack; 17113: Fifth inclined surface; 17114: First recess; 17115: Second protrusion; 1712: Second cam;
17121: Fourth cam surface; 17122: Second inclined surface; 171221: Second rack; 17123: Sixth inclined surface; 17124: First protrusion;
17125: Second recess; 17126: First extension part; 17127: Second extension part; 172: First fastening part; 1721: First clamping block;
17211: Clamping slot; 173: Elastic member; 1731: Spring; 1732: Elastic piece; 174: Second fastening part; 1741: First bump;
17411: Third inclined surface; 17412: Fourth inclined surface; 1742: Second clamping block; 17421: Clamping hole; 175: Sliding part; 1751: Second bump;
17511: Seventh inclined surface; 17512: Eighth inclined surface; 176: Guide rod; 177: First pin shaft; 178: Second pin shaft; 179: Intermediate gear;
18: Synchronization assembly; 181: First driving gear; 182: Second driving gear; 183: Driven gear; 1831: Gear shaft;
119: Second housing fastening bracket; 119a: Third surface; 119b: Fourth surface; 1191: Third sliding slot; 11911: Third slide rail;
1192: Fourth sliding slot; 11921: Fourth slide rail; 1193: Second rotating slot;
120: Second rotating arm; 12001: Third sliding block; 12002: Second protruding part; 120021: Second cam surface;
121: Second swing arm; 12101: Second arc-shaped rotating block; 12102: Fourth sliding block;
12: First support plate; 12a: First plate surface; 1201: First rotating part;
13: Second support plate; 1301: Second rotating part;
2: First housing; 2a: First appearance surface; 2b: First support surface;
3: Second housing; 3a: Second appearance surface; 3b: Second support surface;
4: Flexible display.

### DESCRIPTION OF EMBODIMENTS

To make objectives, technical solutions, and advantages of this application clearer, the following further describes this application in detail with reference to the accompanying drawings.

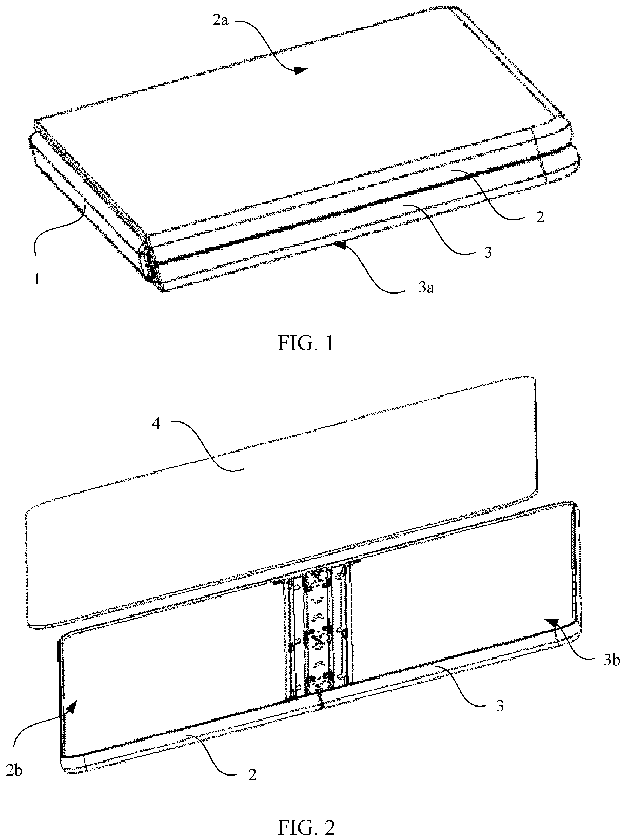

FIG. 1 is a diagram of a structure of an electronic device according to an embodiment of this application. The electronic device may be a mobile phone, a palmtop computer (personal digital assistant, PDA), a notebook computer, a tablet computer, or another device with a foldable function. An example in which an electronic device in an embodiment shown in FIG. 1 is a mobile phone is used for description. The electronic device may include a hinge mechanism, a flexible display, and two housings. For ease of description, the two housings may be respectively named a first housing 2 and a second housing 3. The first enclosure 2 and the second enclosure 3 are located on two sides of the hinge mechanism 1, and may rotate around the hinge mechanism 1. When being used, the electronic device may be folded and unfolded based on different use scenarios. The electronic device provided in this application may be an inwardly foldable electronic device. In the embodiment shown in FIG. 1, the electronic device is in a folded state, and FIG. 1 shows a relative position relationship between the hinge mechanism 1 and the two housings when the electronic device is in the folded state. In this case, a surface of the hinge mechanism 1, a first appearance surface 2a of the first housing 2, and a second appearance surface 3a of the second housing 3 may be jointly used as an appearance surface of the electronic device. The first appearance surface 2a of the first housing 2 is a surface that is of the first housing 2 and that is away from the flexible display. The second appearance surface 3a of the second housing 3 is a surface that is of the second housing 3 and that is away from the flexible display 4.

FIG. 2 is a diagram of a structure of the electronic device, shown in FIG. 1, in an unfolded state. It should be noted that FIG. 2 shows a structure of a side of a first support surface 2b of the first housing 2 and a second support surface 3b of the second housing 3. The first support surface 2b of the first housing 2 is a surface of the first housing 2 for supporting the flexible display 4. The second support surface 3b of the second housing 3 is a surface of the second housing 3 for supporting the flexible display 4. The flexible display 4 may continuously cover the first support surface 2b of the first housing 2, the second support surface 3b of the second housing 3, and the hinge mechanism 1. The flexible display 4 may be fastened to the first support surface 2b of the first housing 2 and the second support surface 3b of the second housing 3. A connection manner thereof may be but is not limited to bonding. In this way, when the electronic device is in the unfolded state shown in FIG. 2, the first housing 2 and the second housing 3 may support the flexible display 4.

In a process in which the first housing 2 and the second housing 3 rotate relative to each other to switch from the unfolded state shown in FIG. 2 to the folded state shown in FIG. 1, or from the folded state shown in FIG. 1 to the unfolded state shown in FIG. 2, the flexible display 4 may be bent or flattened along with the first housing 2 and the second housing 3.

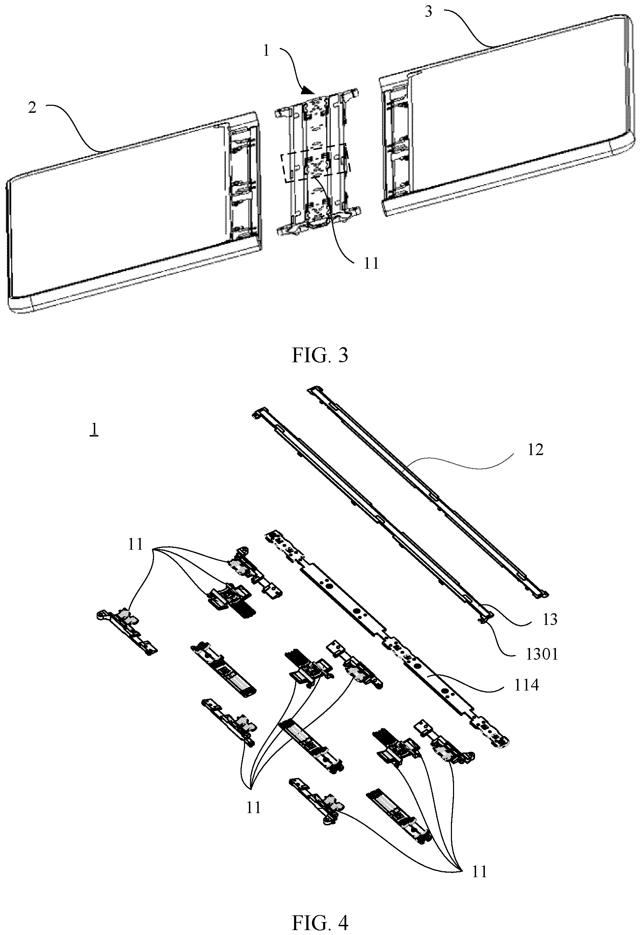

FIG. 3 is a schematic exploded view of the electronic device shown in FIG. 2. It should be noted that the flexible display is not shown in FIG. 3. In this embodiment of this application, the first housing 2 and the second housing 3 may be located on two opposite sides of the hinge mechanism 1. The hinge mechanism 1 may include one main hinge module 11, or may include a plurality of main hinge modules 11. For example, FIG. 4 is a schematic exploded view of a structure of the hinge mechanism 1 shown in FIG. 3. In the embodiment shown in FIG. 4, the hinge mechanism 1 includes three main hinge modules 11. The three main hinge modules 11 may be arranged at intervals in a length direction of the hinge mechanism 1. The length direction of the hinge mechanism 1 may be understood as an extension direction of an axis around which the first housing 2 and the second housing 3 rotate around the hinge mechanism 1. The first housing 2 and the second housing 3 may be rotatably connected through the plurality of main hinge modules 11. In this way, stability of rotation of the first housing 2 and the second housing 3 of the electronic device relative to the hinge mechanism 1 can be effectively improved.

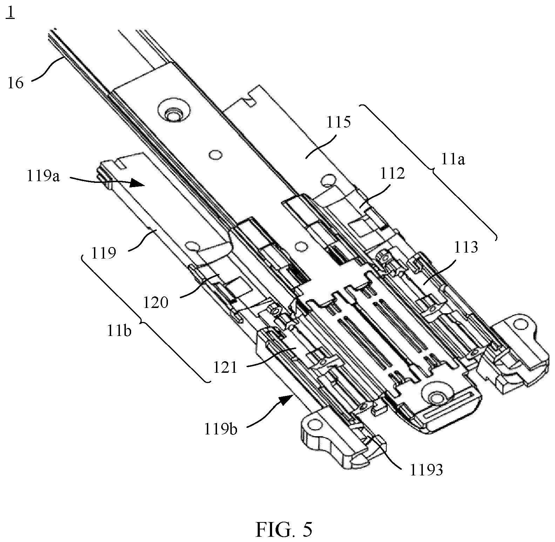

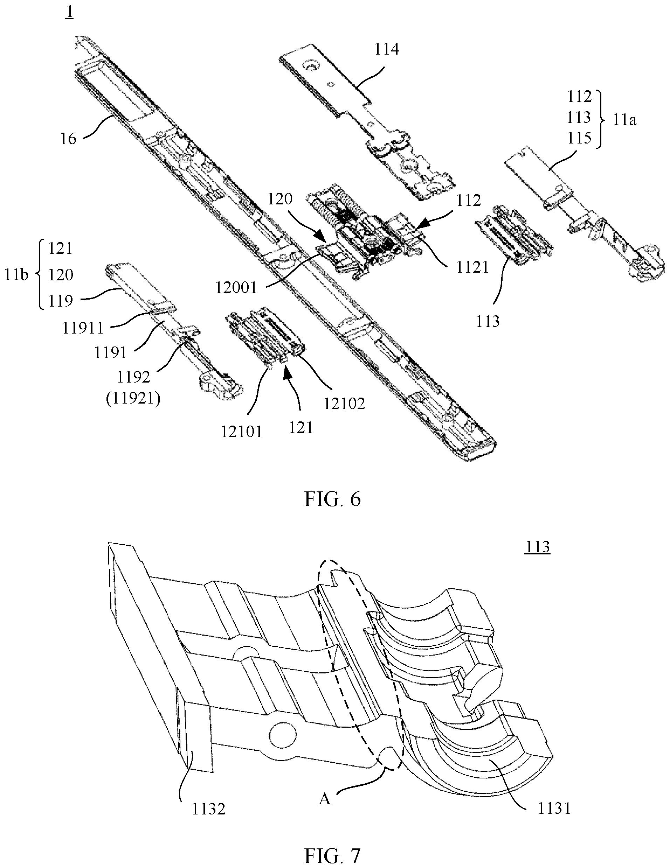

FIG. 5 is a diagram of a partial structure of a hinge mechanism according to a possible embodiment of this application. FIG. 6 is an exploded view of a partial structure of the hinge mechanism shown in FIG. 5. In this embodiment, a main hinge module 11 may include two rotating assemblies. The two rotating assemblies are respectively a first rotating assembly 11a and a second rotating assembly 11b. The hinge mechanism 1 may further include a base 16. The base 16 may serve as a bearing component of the first rotating assembly 11a and the second rotating assembly 11b. The first rotating assembly 11a and the second rotating assembly 11b are disposed on two sides of the base 16 respectively. In some implementation cases, the first rotating assembly 11a and the second rotating assembly 11b may be symmetrically disposed relative to the base 16. For ease of description, in the following embodiments of this application, the main hinge module 11 is described mainly by using a specific disposition manner of the first rotating assembly 11a and a connection relationship between the first rotating assembly 11a and the base 16 as an example, and a side of the second rotating assembly 1 1b may be disposed with reference to a side of the first rotating assembly 11a. It should be noted that a design of the second rotating assembly 11b may be completely the same as that of the first rotating assembly 11a. Alternatively, reference may be made to only components and a connection relationship included in the first rotating assembly 11a. Another parameter may be adaptively adjusted, and is not required to be completely the same.

It should be noted that in a possible embodiment of this application, when there are a plurality of main hinge modules 11, first rotating assemblies 11a and second rotating assemblies 1 1b of the plurality of main hinge modules 11 may all use a same base 16 as the bearing component, to improve an integration degree of the hinge mechanism 1. In some other possible embodiments of this application, the hinge mechanism 1 may have one base 16 corresponding to each main hinge module 11 respectively, so that the first rotating assembly 11a and the second rotating assembly 11b of each main hinge module 11 use the corresponding base 16 as the bearing component.

To better implement unfolding and folding of the hinge mechanism 1, for the hinge mechanism 1 in this application, a damping mechanism that can provide a damping force for the foregoing rotating assemblies is further provided, so that the first rotating assembly and the second rotating assembly can stably rotate under an action of the damping force, to prevent the electronic device from being unfolded or folded mistakenly and further implement hover of the two housings at a set position. In addition, a user may have an obvious feeling in a process of unfolding and folding the electronic device. This helps improve user experience.

Still refer to FIG. 5 and FIG. 6. The first rotating assembly 11a may include a first rotating arm 112. The first rotating arm 112 may be rotatably connected to the base 16. In some embodiments, the first rotating arm 112 may be rotatably connected to the base 16 through a physical shaft. In some other embodiments, the first rotating arm 112 and the base may be rotatably connected through a virtual shaft. For example, an arc-shaped groove may be disposed on the base, and an arc-shaped rotating block is disposed on the first rotating arm 112, so that the arc-shaped rotating block slides along a groove surface of the arc-shaped groove to implement rotation of the first rotating arm 112 relative to the base. Certainly, an arc-shaped arm may also be disposed on the base, and an arc-shaped rotating groove is disposed on the first rotating arm 112, so that the arc-shaped arm slides along a groove surface of the arc-shaped rotating groove to implement the rotation of the first rotating arm 112 relative to the base 16.

In this application, the manner in which such arc-shaped groove and the arc-shaped rotating block are fitted to implement rotation around an axis determined by using a virtual position is referred to as a rotating connection manner using the virtual shaft for short. That is, rotation between two rotating entities is not directly implemented by using a solid pin shaft, but the two rotating entities are rotatably connected through the foregoing fitting structure.

In this embodiment of this application, in a process of folding and unfolding the electronic device, the first rotating arm 112 and a second rotating arm 120 may further slide relative to a first housing and a second housing respectively while rotating around the base, so that the first housing and the second housing can also rotate relative to the base. Based on this design, this application provides a damping assembly. The damping assembly may cooperate with the first rotating arm 112 and the second rotating arm 120 to jointly form the damping mechanism, to provide the damping force for movement of the first rotating arm 112 and the second rotating arm 120.

To present the damping mechanism in this application more clearly and completely, before a specific manner of disposing the damping mechanism in this embodiment of this application is specifically described, this application first provides an example of a specific implementation of a hinge mechanism with reference to FIG. 4 to FIG. 13. In addition to implementing a damping function, the hinge mechanism can further flatly support the flexible display. In an intermediate state and an unfolding or folding process of the electronic device, a bent part of the flexible display can be evenly subject to a force. In addition, when the electronic device is in a folded state, accommodation space can be provided for the flexible display, and the accommodation space may ensure that the bent part of the flexible display has a curvature to a specific extent, to avoid squeezing. Further, the hinge mechanism can further keep a length of the flexible display unchanged in an entire unfolding or folding process of the electronic device, to ensure reliability of the flexible display.

It should be understood that the following embodiment is merely a possible implementation of the hinge mechanism for implementing folding and unfolding functions of the electronic device, and in another embodiment, another manner may be used for implementation. The damping assembly in this embodiment of this application is applicable to all hinge mechanisms in which rotating arms are slidably connected to housings.

Next, an example design of the hinge mechanism is specifically described.

In this application, the first rotating assembly 11a may further include a first swing arm 113. The first swing arm 113 is rotatably connected to the base 16. For example, the first swing arm 113 may be rotatably connected to the base 16 through the virtual shaft. FIG. 7 is a diagram of a structure of the first swing arm 113 according to a possible embodiment of this application. A first arc-shaped rotating block 1131 may be disposed at one end that is of the first swing arm 113 that is connected to the base 16. It should be noted that, in this embodiment of this application, axes for the first rotating arm 112 and the first swing arm 113 to rotate relative to the base 16 are different. In other words, a rotation axis for the first rotating arm 112 to be rotatably connected to the base 16 is different from an axis for the first swing arm 113 to be rotatably connected to the base 16. Specifically, the two axes are parallel to each other, but do not overlap.

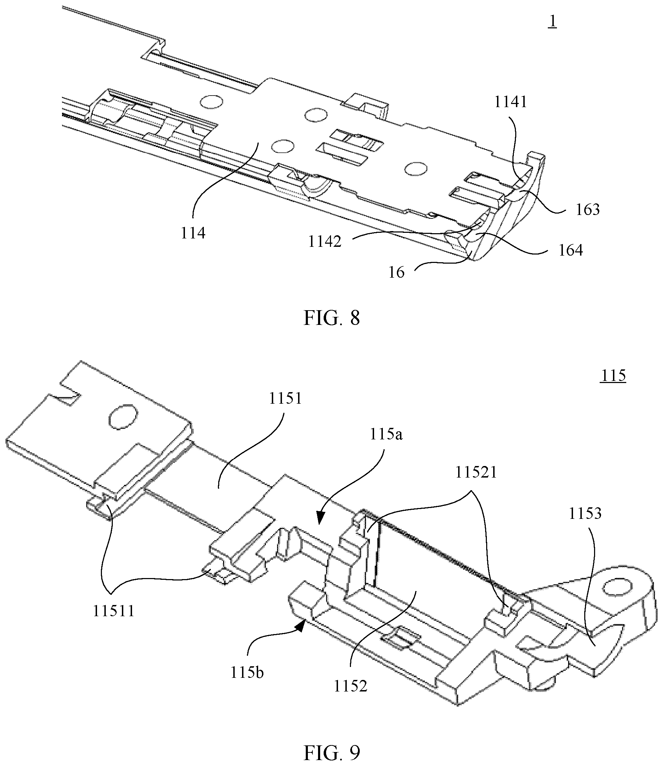

In addition, FIG. 8 is a diagram of a partial structure of the hinge mechanism. A first arc-shaped groove 163 may be disposed on the base 16. The first arc-shaped rotating block 1131 of the first swing arm 113 shown in FIG. 7 may be accommodated in the first arc-shaped groove 163, and may rotate along an arc-shaped surface of the first arc-shaped groove 163, so that the first swing arm 113 rotates around the base 16. The first swing arm 113 is rotatably connected to the base 16 through the virtual shaft. This helps reduce space occupied by the first swing arm 113 on the base 16, so that a volume of the main hinge module 11 can be reduced, to facilitate a miniaturization design of the hinge mechanism 1. It should be noted that in this embodiment of this application, the first arc-shaped rotating block 1131 may be but is not limited to a circular arc-shaped rotating block, and the first arc-shaped groove 163 may be but is not limited to a circular arc-shaped groove.

Still refer to FIG. 8. The hinge mechanism 1 may further include a cover plate 114. The cover plate 114 may cover the base 16, to form accommodating space between the cover plate 114 and the base 16. It should be noted that, in this application, one cover plate 114 may be separately disposed for each main hinge module 11, so that a structure of each main hinge module 11 is flexible. Alternatively, the plurality of main hinge modules 11 may share one cover plate 114, to simplify an overall structure of the hinge mechanism 1. A first arc-shaped protrusion 1141 may be disposed on a surface that is of the cover plate 114 and that faces the first arc-shaped groove 163, and the first arc-shaped rotating block 1131 of the first swing arm 113 shown in FIG. 7 may be inserted between the first arc-shaped protrusion 1141 and the first arc-shaped groove 163. Therefore, the first arc-shaped protrusion 1141 limits the first arc-shaped rotating block 1131 of the first swing arm 113 into the first arc-shaped groove 163 of the base 16, to reduce a risk that the first swing arm 113 falls off from the base 16. This improves movement reliability of the first swing arm 113.

In another possible embodiment of this application, the first arc-shaped groove 163 may further be an integrated channel structure that is directly provided on the base 16. In this way, an integrated design of the base 16 can be implemented, and structural reliability of the hinge mechanism is improved. In addition, a quantity of first arc-shaped grooves 163 may be but is not limited to at least two. The at least two first arc-shaped grooves 163 may be disposed at an interval in a length direction of the base 16, and the at least two first arc-shaped grooves 163 may limit the first arc-shaped rotating block 1131, to improve reliability of a connection between the first arc-shaped rotating block 1131 and the base 16.

In some other embodiments of this application, the first swing arm 113 may alternatively be rotatably connected to the base 16 through the physical shaft. When the hinge mechanism includes the plurality of main hinge modules 11, the first swing arm 113 of at least one of the plurality of main hinge modules 11 may be rotatably connected to the base 16 through the virtual shaft, and the first swing arm 113 of at least one main hinge module 11 is rotatably connected to the base 16 through the physical shaft. In this case, a first swing arm 113 of a main hinge assembly 101 disposed opposite to the flexible display may be rotatably connected to the base 16 in a manner of connection through the virtual shaft, to ensure flat support for the flexible display. First swing arms 113 of main hinge modules 11 located at two end portions of the hinge mechanism in a length direction may be rotatably connected to the base 16 in a manner of connection through the physical shafts, to improve reliability of connections between an overall hinge structure and the first and second housings.

Refer to FIG. 5 and FIG. 6 again. In this embodiment of this application, the first rotating assembly may further include a first housing fastening bracket 115. The first housing fastening bracket 115 may be connected to the first rotating arm 112 and the first swing arm 113.

When the first housing fastening bracket 115 is specifically disposed, refer to FIG. 9. FIG. 9 is a diagram of a structure of the first housing fastening bracket 115 according to a possible embodiment of this application. In this embodiment, the first housing fastening bracket 115 may have a first sliding slot 1151. The first sliding slot 1151 may extend along the first housing fastening bracket 115 in a movement direction (x1 direction) toward or away from the base 16. Refer to FIG. 6 and FIG. 9 together. The first rotating arm 112 may be mounted in the first sliding slot 1151, and may slide in the first sliding slot 1151. In addition, to prevent the first rotating arm 112 from falling off from the first sliding slot 1151, first slide rails 11511 may be disposed on slot walls of the first sliding slot 1151, and a first sliding block 1121 may be disposed on the first rotating arm 112. In this way, the first sliding block 1121 may be clamped in the first slide rails 11511, and the first sliding block 1121 may slide along the first slide rails 11511, to limit the first rotating arm 112 in the first sliding slot 1151. In addition, the first slide rails 11511 are disposed on the slot walls of the first sliding slot 1151, and may provide a guide for sliding of the first rotating arm 112 along the first sliding slot 1151, to improve movement stability of the first rotating arm 112.

Still refer to FIG. 9. The first housing fastening bracket 115 may further have a second sliding slot 1152. In a length direction of the first housing fastening bracket 115, the first sliding slot 1151 and the second sliding slot 1152 are disposed at an interval. Refer to FIG. 7 and FIG. 9 together. An end portion that is of the first swing arm 113 and that faces the first housing fastening bracket 115 may be mounted in the second sliding slot 1152, and the first swing arm 113 may slide in the second sliding slot 1152. It should be noted that, in this application, the first housing fastening bracket 115 may include a first surface 115a and a second surface 115b that are disposed back to each other. The first surface 115a may be a surface of one side that is of the first housing fastening bracket 115 and that faces the flexible display when the hinge mechanism 1 is used in the electronic device. During specific implementation, the second sliding slot 1152 may extend in a direction (y 1 direction) from the first surface 115a to the second surface 115b or from the second surface 115b to the first surface 115a. In addition, a projection of the y1 direction on a first cross section may not be parallel to a projection of the x1 direction on the first cross section. The first cross section may be a reference plane perpendicular to a rotation axis of the first rotating arm 112 and a rotation axis of the first swing arm 113.

In addition, still refer to FIG. 9. In this application, second slide rails 11521 may also be disposed in the second sliding slot 1152, and a second sliding block 1132 may be disposed on the first swing arm 113 shown in FIG. 7. In this way, the second sliding block 1132 may be clamped in the second slide rails 11521, and the second sliding block 1132 may slide in the second slide rails 11521 in the y direction, to limit the first swing arm 113 in the second sliding slot 1152, so as to prevent the first swing arm 113 from falling off from the second sliding slot 1152. In addition, the second slide rails 11521 are disposed on slot walls of the second sliding slot 1152, and may provide a guide for sliding of the first swing arm 113 along the second sliding slot 1152, to improve movement stability of the first swing arm 113.

It can be learned from the foregoing description that in an embodiment of this application, the second rotating assembly 11b and the first rotating assembly 11a may be symmetrically disposed relative to the base 16. During specific implementation, refer to FIG. 5 and FIG. 6 again. The second rotating assembly 11b may also include a second housing fastening bracket 119, the second rotating arm 120, and a second swing arm 121. The second housing fastening bracket 119 has a third surface 119a and a fourth surface 119b that are disposed back to each other. When the hinge mechanism is used in the electronic device, the third surface 119a is a surface of one side that is of the second housing fastening bracket 119 and that faces the flexible display. In addition, the second housing fastening bracket 119 may include a third sliding slot 1191 extending in an x2 direction and a fourth sliding slot 1192 extending in a y2 direction. The second rotating arm 120 may slide in the third sliding slot 1191. The second swing arm 121 may slide in the fourth sliding slot 1192. A projection of the x2 direction on a second cross section is not parallel to a projection of the y2 direction on the second cross section. The second cross section is a reference plane perpendicular to a rotation axis of the second rotating arm 120 and a rotation axis of the second swing arm 121.

In addition, still refer to FIG. 6. Third slide rails 11911 may be disposed in the third sliding slot 1191. A third sliding block 12001 may be disposed on the second rotating arm 120. A fourth slide rail 11921 may be disposed in the fourth sliding slot 1192. A fourth sliding block 12102 may be disposed on the second swing arm 121. For a manner of disposing the third slide rails 11911, refer to that of the first slide rails 11511. For a manner of disposing the third sliding block 12001, refer to that of the first sliding block 1121. For a manner of disposing the fourth slide rail 11921, refer to that of the second slide rails 11521. For a manner of disposing the fourth sliding block 12102, refer to that of the second sliding block 1132. Details are not described herein again.

In this application, the second swing arm 121 may be disposed with reference to the first swing arm 113 shown in FIG. 7. To implement a rotating connection between the second swing arm 121 and the base 16, refer to FIG. 8. The base 16 may include a second arc-shaped groove 164. A second arc-shaped rotating block 12101 is disposed on the second swing arm 121 (refer to FIG. 6). In addition, a second arc-shaped protrusion 1142 may be disposed on a surface that is of the cover plate 114 and that faces the second arc-shaped groove 164. The second arc-shaped groove 164 may be disposed with reference to the first arc-shaped groove 163. The second arc-shaped rotating block 12101 may be disposed with reference to the first arc-shaped rotating block 1131. The second arc-shaped protrusion 1142 may be disposed with reference to the first arc-shaped protrusion 1141. Details are not described herein.

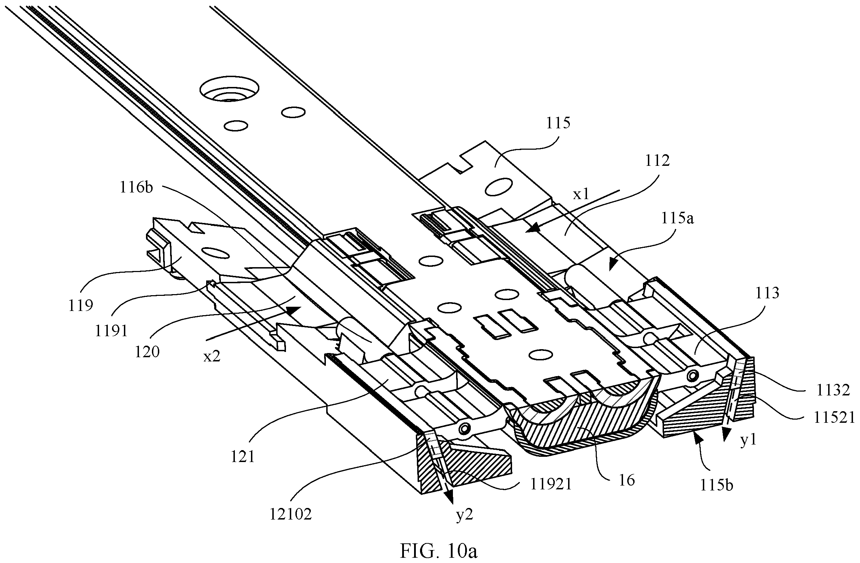

After connection relationships, provided in the foregoing embodiment of this application, between the first rotating assembly 11a and the base 16 and between the second rotating assembly 1 1b and the base 16 are understood, the following describes a movement process of the hinge mechanism. First, FIG. 10a is a diagram of a structure of the hinge mechanism in an unfolded state. In this case, a distance between an edge that is of the first housing fastening bracket 115 and that faces the base 16 and the base 16 is the shortest, and a distance between the second sliding block 1132 of the first swing arm 113 and the first surface 115a of the first housing fastening bracket 115 is the shortest.

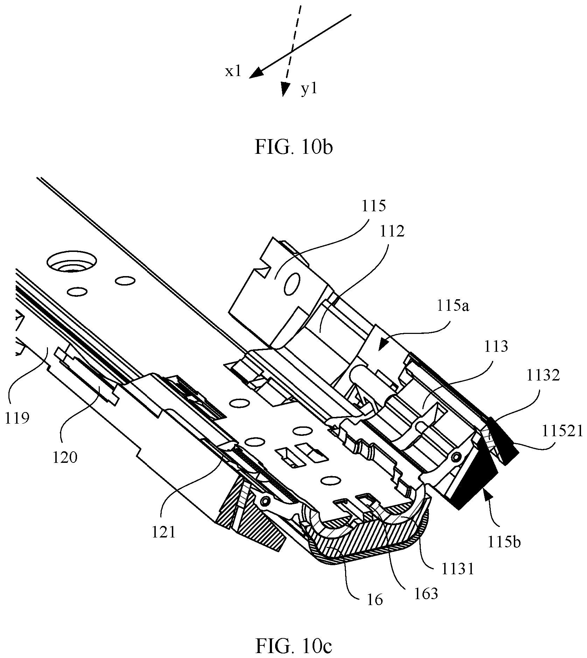

It can be learned from the description of the foregoing embodiment that, when the hinge mechanism rotates from the unfolded state to a folded state, the first rotating arm 112 may slide in the first sliding slot 1151 in a first direction, and the first swing arm 113 may slide in the second sliding slot 1152 in a second direction. Similarly, the second rotating arm 120 may slide in the third sliding slot 1191 along x2, and the second swing arm 121 may slide in the fourth sliding slot 1192 along y2. In FIG. 10a, solid lines with arrows respectively indicate the x1 direction and the x2 direction, and dashed lines with arrows respectively indicate the y1 direction and the y2 direction. In addition, FIG. 10b is a diagram of the first cross section according to a possible embodiment. In the first cross section, the x1 direction intersects with the y1 direction, and an angle at which the x1 direction intersects with the y1 direction may be an acute angle shown in the figure, or may be another possible angle, for example, a right angle or an obtuse angle. In addition, in the second cross section, a position relationship between the x2 direction and the y2 direction may be symmetrical to a position relationship between the x1 direction and the y1 direction shown in FIG. 10b. Details are not described herein.

FIG. 10c is a diagram of a structure of the hinge mechanism in an intermediate state. It can be learned by comparing FIG. 10c and FIG. 10a that, in this process, the first housing fastening bracket 115 may move in a direction away from the base 16 relative to the first rotating arm 112, and drive the first rotating arm 112 and the first swing arm 113 to rotate around the base 16. The first arc-shaped rotating block 1131 of the first swing arm 113 moves in a direction of sliding out of the corresponding first arc-shaped groove 163, so that a part that is of the first arc-shaped rotating block 1131 and that is accommodated in the corresponding first arc-shaped groove 163 is reduced. At the same time, the second sliding block 1132 of the first swing arm 113 slides in the second slide rails 11521 in a direction from the first surface 115a of the first housing fastening bracket 115 to the second surface 115b. Similarly, the second housing fastening bracket 119 may drive the second rotating arm 120 and the second swing arm 121 to rotate around the base. A specific movement process thereof is similar to a movement process in which the first housing fastening bracket 115 drives the first rotating arm 112 and the first swing arm 113 to rotate around the base 16. Details are not described herein.

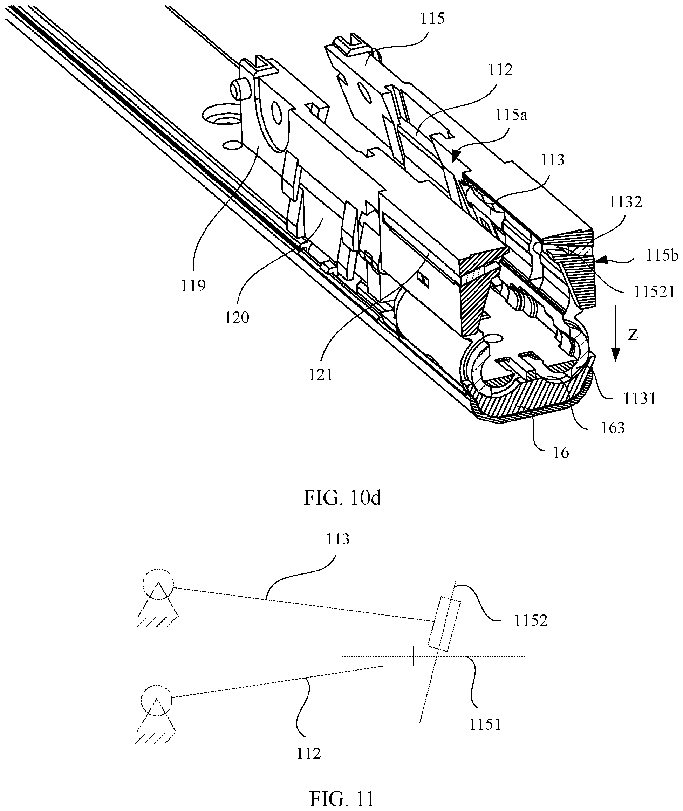

In addition, FIG. 10d is a diagram of a structure of the hinge mechanism in the folded state. In a process from FIG. 10c to FIG. 10d, the first housing fastening bracket 115 continues to move in a direction away from the base 16 relative to the first rotating arm 112, and drives the first rotating arm 112 to rotate around the base 16. The first arc-shaped rotating block 1131 of the first swing arm 113 continues to move in the direction of sliding out of the corresponding first arc-shaped groove 163, so that the part of the first arc-shaped rotating block 1131 and that is accommodated in the corresponding first arc-shaped groove 163 is further reduced. At the same time, the second sliding block 1132 of the first swing arm 113 continues to slide in the second sliding slot 1152 in the direction toward the second surface 115b of the first housing fastening bracket 115. Similarly, the second housing fastening bracket 119 may drive the second rotating arm 120 and the second swing arm 121 to continue to rotate around the base. The specific movement process thereof is similar to the movement process in which the first housing fastening bracket 115 drives the first rotating arm 112 and the first swing arm 113 to rotate around the base 16. Details are not described herein.

It may be understood that, when the electronic device rotates from the folded state shown in FIG. 10d to the unfolded state shown in FIG. 10a, the first housing fastening bracket 115, the first rotating arm 112, the first swing arm 113, the second housing fastening bracket 119, the second rotating arm 120, and the second swing arm 121 may separately move in directions opposite to those in the foregoing rotation processes in FIG. 10a to FIG. 10d. Details are not described herein.

FIG. 11 is a principle diagram of a mechanism in which the first rotating arm 112 and the first swing arm 113 slide relative to the first housing fastening bracket 115 according to an embodiment of this application. It can be learned from FIG. 11 that, the hinge mechanism 1 provided in this application is used. When the first rotating arm 112 and the first swing arm 113 rotate around the base 16, rotation axes of the first rotating arm 112 and the first swing arm 113 do not overlap. In this way, a phase difference between the first rotating arm 112 and the first swing arm 113 can be implemented, to implement the movement process in FIG. 10a to FIG. 10d. In addition, directions in which the first sliding slot 1151 and the second sliding slot 1152 are provided are appropriately designed, so that angles by which the first rotating arm 112 and the first swing arm 113 rotate relative to the base 16 are not greater than 90°. Compared with an existing solution, in this solution, a rotation angle of the first swing arm 113 can be effectively reduced. In this way, a wall thickness design of a partial structure of the first swing arm 113 (for example, a structure at a position A of the first swing arm 113 shown in FIG. 7) can meet a strength requirement, so that structural reliability of the first swing arm 113 is improved. It may be understood that FIG. 11 may also indicate a principle of a mechanism in which the second rotating arm 120 and the second swing arm 121 slide relative to the second housing fastening bracket 119. It can be learned from the foregoing analysis that, in this application, the directions in which the third sliding slot 1191 and the fourth sliding slot 1192 are provided are appropriately designed, so that angles by which the second rotating arm 120 and the second swing arm 121 rotate relative to the base 16 are not greater than 90°. Therefore, a rotation angle of the second swing arm 121 is reduced. In this way, a wall thickness design of a partial structure of the second swing arm 121 meets the strength requirement, so that structural reliability of the second swing arm 121 is improved. In addition, when the hinge mechanism 1 is used in the electronic device, a design of thinning components in the electronic device to avoid rotation of the first swing arm 113 and the second swing arm 121 can be effectively avoided. This can improve reliability of an overall structure of the electronic device.

In addition, still refer to FIG. 10d. When the hinge mechanism is in the folded state, because the first rotating arm 112 and the first swing arm 113 each have a support force for the first housing fastening bracket 115 in a Z direction shown in FIG. 10d. The support forces can effectively improve movement integration degrees between the first rotating arm 112 and the first housing fastening bracket 115 and between the first swing arm 113 and the first housing fastening bracket 115, and have a function of stopping the first housing fastening bracket 115 in the direction. Similarly, the second rotating arm 120 and the second swing arm 121 may also have support forces for the second housing fastening bracket 119 in the Z direction. The support forces can effectively improve movement integration degrees between the second rotating arm 120 and the second housing fastening bracket 119 and between the second swing arm 121 and the second housing fastening bracket 119, and have a function of stopping the second housing fastening bracket 119 in the direction. In this way, even if the electronic device in which the hinge mechanism is used falls in the folded state, a risk that in the state, the first housing fastening bracket 115 and the second housing fastening bracket 119 have large instantaneous displacement relative to the hinge mechanism can be effectively reduced. This can ensure reliability of the overall structure of the electronic device.

Refer to FIG. 4 again. In this embodiment of this application, the hinge mechanism may further include a first support plate 12 and a second support plate 13. The first support plate 12 and the second support plate 13 may be disposed on two opposite sides of the base 16 shown in FIG. 5 respectively. In an embodiment of this application, the first support plate 12 and the second support plate 13 may be symmetrically disposed relative to the base 16.

In this embodiment of this application, the first support plate 12 is rotatably connected to the first housing fastening bracket 115. It should be noted that the first support plate 12 may be rotatably connected to a plurality of first housing fastening brackets 115 of the plurality of main hinge modules 11. This helps simplify the structure of the hinge mechanism 1, and can improve the structural reliability of the hinge mechanism 1.

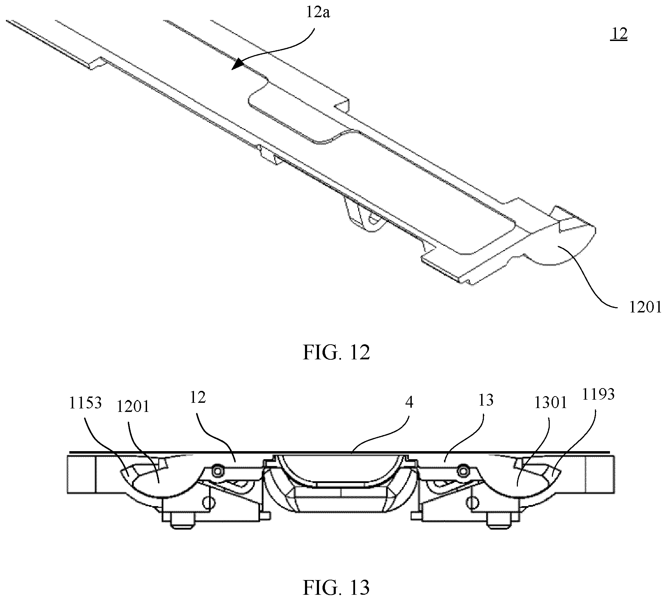

Specifically, when the first support plate 12 is rotatably connected to the first housing fastening bracket 115, first refer to the first housing fastening bracket 115 shown in FIG. 9. The first housing fastening bracket 115 may further have a first rotating slot 1153, and the first rotating slot 1153 may be a circular arc-shaped slot. In addition, FIG. 12 is a diagram of a structure of the first support plate 12 according to a possible embodiment of this application. A first rotating part 1201 may be disposed at an end portion that is of the first support plate 12 and that faces the first housing fastening bracket 115, and the first rotating part 1201 may be disposed in an arc-shaped shape, for example, may be in a circular arc-shaped shape. In this way, the first rotating part 1201 may be mounted in the first rotating slot 1153, and the first rotating part 1201 may rotate along a slot surface of the first rotating slot 1153, to implement relative rotation between the first support plate 12 and the first housing fastening bracket 115.

FIG. 13 is a diagram of a structure in which the first support plate 12 and the second support plate 13 support the flexible display 4 according to a possible embodiment of this application. The second support plate 13 and the first support plate 12 are symmetrically disposed. Therefore, when the second support plate 13 is specifically disposed, the second support plate 13 may be rotatably connected to the second housing fastening bracket 119. The second housing fastening bracket 119 has a second rotating slot 1193. In addition, a second rotating part 1301 may be disposed on the second support plate 13, so that the second rotating part 1301 rotates along a slot surface of the second rotating slot 1193, to implement relative rotation between the second support plate 13 and the second housing fastening bracket 119.

Refer to FIG. 12 and FIG. 13 together. The first support plate 12 may include a first plate surface 12a. The first plate surface 12a may be configured to support the flexible display. When the electronic device is in the unfolded state, the first plate surface 12a of the first support plate 12 and a surface that is of the cover plate (not shown in FIG. 12) and that faces the flexible display 4 may be in a same plane, so that the flexible display 4 can be flatly supported. Similarly, the second support plate 13 also has a second plate surface (not shown in the figure) configured to support the flexible display. When the electronic device is in the unfolded state, the second plate surface of the second support plate 13 and the surface that is of the cover plate and that faces the flexible display 4 may be in the same plane.

As described above, the hinge mechanism is used, the rotation axes of the first rotating arm and the first swing arm do not overlap, and the rotation axes of the second rotating arm and the second swing arm do not overlap. In this way, a phase difference between the rotating arm and the swing arm that are disposed on a same side may be implemented in a rotation process of the hinge mechanism, to implement extension/retraction movement of the two rotating assemblies, so that when the hinge mechanism is in the unfolded state, the hinge mechanism can smoothly support the flexible display of the electronic device, and when the hinge mechanism is in the folded state, water drop-like display accommodation space that meets a bending requirement of the flexible display can be formed. In addition, in this application, the directions in which the first sliding slot and the second sliding slot that are of the first housing fastening bracket are provided and the directions in which the third sliding slot and the fourth sliding slot that are of the second housing fastening bracket are provided are appropriately designed, so that the angles by which the first swing arm and the second swing arm rotate relative to the base may be reduced. In this way, wall thickness designs of partial structures of the first swing arm and the second swing arm can meet the strength requirement, so that structural reliability of the first swing arm and the second swing arm is improved. When the hinge mechanism is used in the electronic device, the design of thinning components in the electronic device to avoid rotation of the first swing arm and the second swing arm can be effectively avoided. This can improve the reliability of the overall structure of the electronic device. In addition, a risk of squeezing of the flexible display of the electronic device caused by rotation of the first swing arm and the second swing arm can be further reduced, a risk of damage to the flexible display can be reduced, and a service life of the flexible display can be prolonged.

After the first rotating assembly and the second rotating assembly of the hinge mechanism are described, the following further describes a damping assembly in detail.

In this embodiment of this application, the damping assembly may be disposed in each main hinge module. In other words, in addition to the first rotating assembly and the second rotating assembly, each main hinge module further includes the damping assembly configured to provide a damping force for the first rotating assembly and the second rotating assembly. The following specifically describes a structure of the damping assembly.

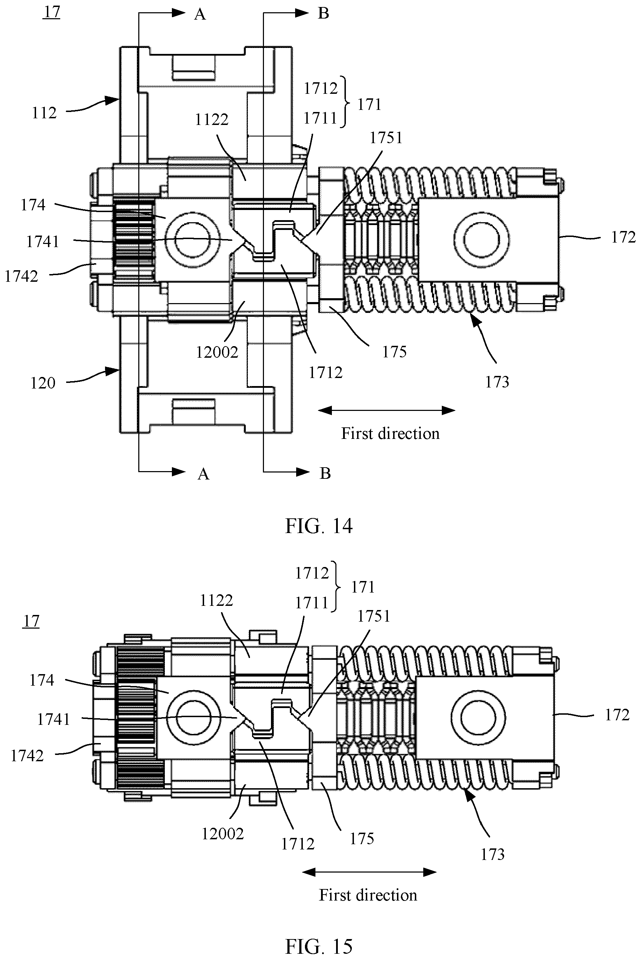

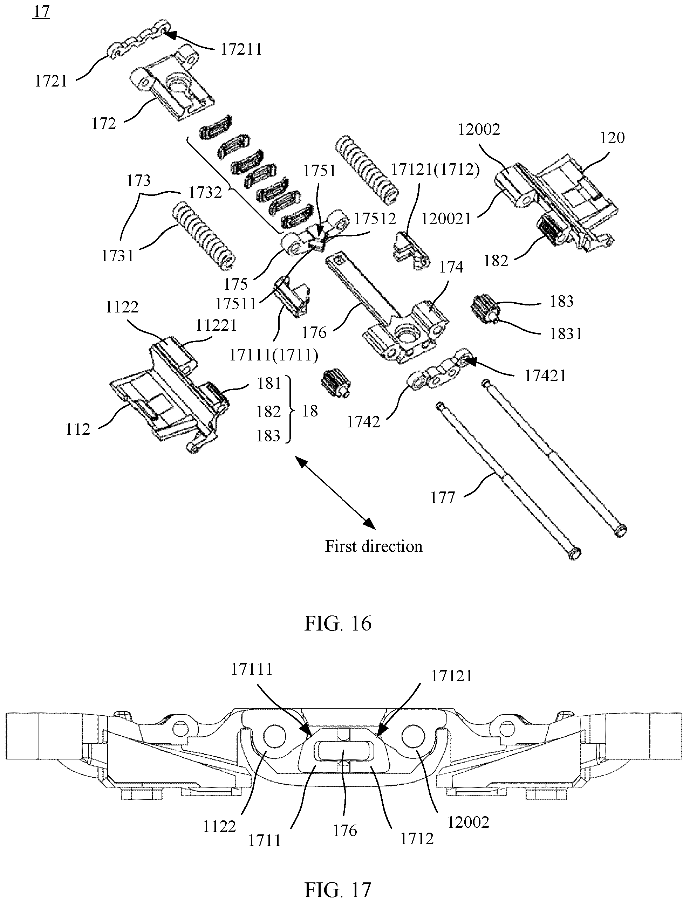

FIG. 14 is a diagram of a partial structure of a hinge mechanism in an unfolded state according to an embodiment of this application. FIG. 15 is a diagram of a partial structure of the hinge mechanism, shown in FIG. 14, in a folded state. FIG. 16 is a schematic exploded view of a structure of the hinge mechanism shown in FIG. 14. In this embodiment, a damping assembly 17 may include a transmission member 171, a first fastening part 172, and an elastic member 173. The transmission member 171 may be slidably disposed on a base in a first direction. The first fastening part 172 is fastened on the base. The first fastening part 172 and the transmission member 171 are disposed at an interval in the first direction. One end of the elastic member 173 may elastically abut against the first fastening part 172, and the other end of the elastic member 173 may elastically abut against the transmission member 171, so that the elastic member is elastically limited between the transmission member 171 and the first fastening part 172. The first direction is specifically an extension direction of a rotation axis of a first rotating arm 112 and a second rotating arm 120, that is, a length direction of the hinge mechanism.

The transmission member 171 may be located between the first rotating arm 112 and the second rotating arm 120. In addition, a first protruding part 1122 may be disposed on one side that is of the first rotating arm 112 and that faces the transmission member 171. One surface that is of the first protruding part 1122 and that faces the transmission member 171 has a first cam surface 11221. Similarly, a second protruding part 12002 may be disposed on one side that is of the second rotating arm 120 and that faces the transmission member 171. One surface that is of the second protruding part 12002 and that faces the transmission member 171 has a second cam surface 120021. To be specific, the transmission member 171 is located between the first cam surface 11221 of the first rotating arm 112 and the second protruding part 12002 of the second rotating arm 120. Herein, the cam surface may be understood as a surface formed by a curved contour on the first protruding part 1122 or the second protruding part 12002. Two sides of the transmission member 171 may respectively abut against the first cam surface 11221 and the second cam surface 120021. In this way, when the first rotating arm 112 and the second rotating arm 120 rotate, the transmission member 171 may be pushed by the first rotating arm 112 and the second rotating arm 120 on the two sides to slide on the base in the first direction, so that an extension/retraction status of the elastic member 173 limited between the transmission member 171 and the first fastening part 172 changes. While the elastic member 173 is deformed, a specific elastic force is also applied to the transmission member 171. The elastic force may be further transmitted to the first rotating arm 112 and the second rotating arm 120 on the two sides through the transmission member 171, so that the first rotating arm 112 and the second rotating arm 120 are subject to radial abutting forces from the transmission member 171 in a rotation process. In addition, the abutting force may be converted into the damping force for the first rotating arm 112 and the second rotating arm 120 to rotate relative to the base, so that the first rotating arm 112 and the second rotating arm 120 can stably rotate under an action of the damping force. It should be noted that a radial direction in this embodiment of this application may be understood as a direction close to or away from the base. Specifically, in this solution, a radial abutting force from the transmission member 171 to which the first rotating arm 112 is subject is an abutting force in the direction away from the base. The radial abutting force from the transmission member 171 to which the second rotating arm 120 is subject is also the abutting force in the direction away from the base. The directions of forces applied to the first rotating arm 112 and the second rotating arm 120 are opposite, and magnitudes of the forces are approximately equal.

In some possible embodiments, the damping assembly 17 may further include a second fastening part 174. The second fastening part 174 may be fastened to the base. The second fastening part 174 may abut against one side that is of the transmission member 171 and that is away from the first fastening part 172, so that the transmission member 171 is positioned on the side. In addition, the second fastening part 174 and the base may be, but not limited to, threaded through a fastener such as a screw or a bolt, or may be clamped by using a fastener, or may be fastened through bonding by using a bonding agent, or the like. Similarly, the first fastening part 172 and the base may also be fastened in the foregoing manner, and details are not described herein again.

In addition, the damping assembly 17 may further include a sliding part 175. The sliding part 175 may be slidably disposed on the base in the first direction. The sliding part 175 may abut against one side that is of the transmission member 171 and that faces the first fastening part 172. In this case, two ends of the elastic member 173 may elastically abut against the first fastening part 172 and the sliding part 175 respectively. When the transmission member 171 is pushed by the first rotating arm 112 and the second rotating arm 120 on the two sides to slide in the first direction, the sliding part 175 may be driven to slide synchronously, so that the sliding part 175 compresses the elastic member 173. The elastic force generated by the elastic member 173 may be sequentially transmitted to the first rotating arm 112 and the second rotating arm 120 through the sliding part 175 and the transmission member 171. In this embodiment, a width of the sliding part 175 may be equivalent to a width of the first fastening part 172, to reliably limit the elastic member disposed between the sliding part 175 and the first fastening part 172, so that the elastic force may be reliably transmitted to the transmission member 171.

When the transmission member 171 is slidably disposed on the base, the damping assembly 17 may further include a guide rod 176. The guide rod 176 is fastened on the base in the first direction. For example, two ends of the guide rod may be fastened to the first fastening part 172 and the second fastening part 174 respectively. In this case, both the transmission member 171 and the sliding part 175 may be sleeved on the guide rod 176, so that sliding of the transmission member 171 and the sliding part 175 is guided by using the guide rod 176. This improves sliding stability of the transmission member 171 and the sliding part 175 in the first direction.

Refer to FIG. 14 to FIG. 17 together. FIG. 17 is a diagram of a structure of a cross section of the hinge mechanism shown in FIG. 14 at A-A. In this embodiment, the transmission member 171 may include a first cam 1711 and a second cam 1712. The first cam 1711 is located on one side close to the first rotating arm 112. The second cam 1712 is located on one side close to the second rotating arm 120. The first cam 1711 abuts against the first cam surface 11221 of the first rotating arm 112. The second cam 1712 abuts against the second cam surface 120021 of the second rotating arm 120. It can also be seen from FIG. 16 that, one side that is of the first cam 1711 and that faces the first rotating arm 112 may have a third cam surface 17111. One side that is of the second cam 1712 and that faces the second rotating arm 120 may have a fourth cam surface 17121. In this case, the first cam 1711 and the first rotating arm 112 may form a cam pair, and the second cam 1712 and the second rotating arm 120 may form a cam pair. When the first rotating arm 112 and the second rotating arm 120 rotate, the first cam 1711 and the second cam 1712 may slide toward (close to each other) or away from (away from each other) each other. In this embodiment, the first cam 1711 and the second cam 1712 may be designed to slide toward each other when the first rotating arm 112 and the second rotating arm 120 rotate in a direction of folding the electronic device, and slide away from each other when the first rotating arm 112 and the second rotating arm 120 rotate in a direction of unfolding the electronic device. Specifically, this may be implemented by designing curved contours of the first cam surface 11221, the second cam surface 120021, the third cam surface 17111, and the fourth cam surface 17121. It may be understood that, the curved contours of the foregoing several cam surfaces are appropriately designed, so that the first rotating arm 112 and the second rotating arm 120 may further be enabled to hover at a set rotation angle. This helps improve user experience.

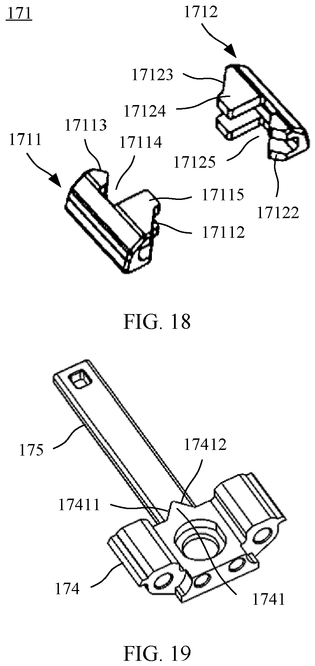

FIG. 18 is a diagram of a structure of the transmission member 171 shown in FIG. 14. One surface that is of the first cam 1711 and that faces the second cam 1712 may further have a first inclined surface 17112. One surface that is of the second cam 1712 and that faces the first cam 1711 may have a second inclined surface 17122. The first inclined surface 17112 and the second inclined surface 17122 may be disposed in parallel to form an inclined surface transmission pair. When the first cam 1711 and the second cam 1712 slide toward or away from each other, at least one of the first cam 1711 and the second cam 1712 may slide in the first direction by using a force on the inclined surface of the cam, to compress the elastic member 173.

Refer to FIG. 18 and FIG. 19 together. FIG. 19 is a diagram of a structure of the second fastening part and a sliding part according to an embodiment of this application. In a specific embodiment, one side that is of the second fastening part 174 and that faces the transmission member 171 may have a first bump 1741. One side that is of the first bump 1741 and that faces the first cam 1711 has a third inclined surface 17411, and one side that faces the second cam 1712 has a fourth inclined surface 17412. In this case, the first inclined surface 17112 of the first cam 1711 may be specifically located at one end that is of the first cam 1711 and that is close to the second fastening part 174, and the first inclined surface 17112 and the third inclined surface 17411 may be disposed in parallel and abut against each other. Similarly, the second inclined surface 17122 of the second cam 1712 may be located at one end that is of the second cam 1712 and that is close to the second fastening part 174, and the second inclined surface 17122 and the fourth inclined surface 17412 may be disposed in parallel and abut against each other.

With reference to FIG. 14 to FIG. 19, in a process in which the first rotating arm 112 and the second rotating arm 120 rotate toward the direction of unfolding the electronic device (that is, the first rotating arm 112 and the second rotating arm 120 rotate away from each other), based on an inclined surface transmission pair formed by the first inclined surface 17112 and the third inclined surface 17411, when the first rotating arm 112 drives the first cam 1711 to slide toward one side that is close to the second cam 1712, the first cam 1711 slides, at the same time under an abutting action of the third inclined surface 17411, toward one side that is away from the second fastening part 174. In other words, an actual movement trajectory of the first cam 1711 is sliding in an inclination direction of the third inclined surface 17411. Similarly, based on an inclined surface transmission pair formed by the second inclined surface 17122 and the fourth inclined surface 17412, when the second rotating arm 120 drives the second cam 1712 to slide toward one side that is close to the first cam 1711, the second cam 1712 slides, at the same time under an abutting action of the fourth inclined surface 17412, toward one side that is away from the second fastening part 174. In other words, an actual movement trajectory of the second cam 1712 is sliding in an inclination direction of the fourth inclined surface 17412. It can be learned that, in this process, both the first cam 1711 and the second cam 1712 may generate sliding movement in the first direction. Therefore, the first cam 1711 and the second cam 1712 may jointly compress the elastic member 173. It can be learned that, in a process of unfolding the electronic device, a user may obtain an obvious operation feel through a compression action on the elastic member 173. This helps improve user experience.

In a process in which the first rotating arm 112 and the second rotating arm 120 rotate toward the direction of folding the electronic device (that is, the first rotating arm 112 and the second rotating arm 120 rotate toward each other), the elastic member 173 gradually rebounds in a compressed state, and releases accumulated elastic potential energy, to push the first cam 1711 and the second cam 1712 to slide in a direction away from the first fastening part 172. Based on the inclined surface transmission pair formed by the first inclined surface 17112 and the third inclined surface 17411, while the first cam 1711 slides in a direction close to the second fastening part 174, displacement of sliding in a direction toward the first rotating arm 112 is also generated, so that a torque force action that helps the rotation of the first rotating arm 112 may be applied to the first rotating arm 112. Similarly, based on the inclined surface transmission pair formed by the second inclined surface 17122 and the fourth inclined surface 17412, while the second cam 1712 slides in the direction close to the second fastening part 174, displacement of sliding in a direction toward the second rotating arm 120 is also generated, so that a torque force action that helps the rotation of the second rotating arm 120 may be applied to the second rotating arm 120. It can be learned that, in a process of folding the electronic device, specific folding assistance may be provided for the hinge mechanism by using the elastic potential energy released by the elastic member 173, to reduce difficulty of a folding operation of the electronic device.

A specific shape of the first bump 1741 is not limited. For example, the first bump 1741 may be a triangular bump. In this case, a width size of the first bump 1741 is relatively small. Therefore, this helps reduce an overall width of the hinge mechanism. Further, the first bump 1741 may be specifically an isosceles triangular bump. In other words, inclination angles of the third inclined surface 17411 and the fourth inclined surface 17412 relative to the first direction may be equal. In this way, when the first cam 1711 and the second cam 1712 slide toward each other, sliding distances of the first cam 1711 and the second cam 1712 in the first direction may also be the same, so that a same compression amount can be generated for the elastic member 173, and further, the first rotating arm 112 and the second rotating arm 120 may be subject to actions of damping forces of an equal magnitude, to improve working reliability of the damping assembly 17.

Certainly, in some other embodiments, the first bump 1741 may alternatively be a trapezoidal structure or another polygonal structure, provided that features of the third inclined surface 17411 and the fourth inclined surface 17412 can be implemented. Details are not described herein again.

Based on a same principle, displacement may also be transmitted between the first cam 1711 and the sliding part 175 and between the second cam 1712 and the sliding part 175 by using the inclined surface transmission pairs. During specific implementation, one end that is of the first cam 1711 and that is close to the sliding part 175 has a fifth inclined surface 17113 that is disposed facing the second cam 1712. One end that is of the second cam 1712 and that is close to the sliding part 175 has a sixth inclined surface 17123 disposed facing the first cam 1711. One side that is of the sliding part 175 and that faces the transmission member 171 may have a second bump 1751. One side that is of the second bump 1751 and that faces the first cam 1711 has a seventh inclined surface 17511, and one side that faces the second cam 1712 has an eighth inclined surface 17512. The fifth inclined surface 17113 of the first cam 1711 and the seventh inclined surface 17511 of the second bump 1751 are disposed in parallel and abut against each other. The sixth inclined surface 17123 of the second cam 1712 and the eighth inclined surface 17512 of the second bump 1751 are disposed in parallel and abut against each other. During specific implementation, the second bump 1751 may also be in a shape such as a triangle or a trapezoid, provided that features of the seventh inclined surface 17511 and the eighth inclined surface 17512 can be implemented. Details are not described herein again.

In a process in which the first rotating arm 112 and the second rotating arm 120 rotate toward the direction of folding the electronic device, an inclined surface transmission pair formed by the fifth inclined surface 17113 and the seventh inclined surface 17511 and a transmission pair formed by the sixth inclined surface 17123 and the eighth inclined surface 17512 are used, and when the first cam 1711 and the second cam 1712 slide toward one side that is close to the first fastening part 172, the first cam 1711 applies an acting force F1 perpendicular to the fifth inclined surface 17113 to the sliding part 175, and the second cam 1712 applies an acting force F2 perpendicular to the sixth inclined surface 17123 to the sliding part 175. It may be understood that directions of component forces of F1 and F2 in a radial direction (that is, a width direction of the base) are opposite, and therefore, the component forces may cancel each other out. In addition, the directions of the component forces of F1 and F2 in the first direction are the same, and therefore, the component forces may be superimposed and applied to the sliding part 175, to push the sliding part 175 to slide in the first direction, so that the sliding part 175 compresses the elastic member 173.

In a process in which the first rotating arm 112 and the second rotating arm 120 rotate toward the direction of folding the electronic device, the elastic member 173 gradually rebounds in the compressed state, and releases the accumulated elastic potential energy, to push the sliding part 175 to slide in the direction away from the first fastening part 172. The inclined surface transmission pair formed by the fifth inclined surface 17113 and the seventh inclined surface 17511 is used, and while the first cam 1711 slides in the direction close to the second fastening part 174, the displacement of sliding in the direction toward the first rotating arm 112 is also generated. Similarly, the transmission pair formed by the sixth inclined surface 17123 and the eighth inclined surface 17512 is used, and while the second cam 1712 slides in the direction close to the second fastening part 174, the displacement of sliding in the direction toward the second rotating arm 120 is also generated. It can be learned in cooperation with the inclined surface transmission pair formed by the first inclined surface 17112 and the third inclined surface 17411 and the inclined surface transmission pair formed by the second inclined surface 17122 and the fourth inclined surface 17412 that, in this process, the first cam 1711 actually slides in the radial direction under a joint action of the seventh inclined surface 17511 and the third inclined surface 17411, and the second cam 1712 slides in the radial direction under a joint action of the eighth inclined surface 17512 and the fourth inclined surface 17412. Therefore, movement reliability of the damping assembly 17 can be effectively improved.

It can be learned from the foregoing description that, in the damping assembly 17 provided in this embodiment of this application, an inclined surface transmission pair formed by the first cam 1711 and the second cam 1712 is used, so that the elastic force generated by the elastic member 173 in an axial direction (that is, the first direction) of the hinge mechanism may be converted into a radial force and transmitted to the first rotating arm 112 and the second rotating arm 120. Because the elastic member 173 is disposed in the axial direction of the hinge mechanism, a size of the elastic member 173 is not limited by another component (for example, a mainboard or a battery) of the electronic device. Therefore, the size of the elastic member 173 may be appropriately increased to ensure that an enough damping force is provided for the electronic device, so that a limitation on an unfolding and folding force of the electronic device may be avoided. In addition, in view of a thin design trend of the electronic device, a thickness size of the hinge mechanism decreases accordingly. In comparison, axial space of the hinge mechanism is relatively sufficient. Therefore, during a design, axial sizes of the first cam 1711 and the second cam 1712 may be appropriately increased to increase a contact area between the first cam 1711 and the rotating arm on the corresponding side and a contact area between the second cam 1712 and the rotating arm on the corresponding side. In this way, contact stress of the first cam 1711 and the second cam 1712 can be reduced on the premise of ensuring space, so that service lives of the two cams can be increased.

Still refer to FIG. 15, FIG. 16, and FIG. 18. One side that is of the first cam 1711 and that faces the second cam 1712 has a first recess 17114. The first recess 17114 may be located on one side that is of the first inclined surface 17112 and that is away from the second fastening part 174. Correspondingly, one side that is of the second cam 1712 and that faces the first cam 1711 may have a first protrusion 17124. The first protrusion 17124 may be located on one side that is of the second inclined surface 17122 and that is away from the second fastening part 174. The first protrusion 17124 may be slidably disposed in the first recess 17114. One side wall that is of the first protrusion 17124 and that is away from the second fastening part 174 may abut against an inner wall of the first recess 17114. The first protrusion 17124 and the first recess 17114 are fitted, so that sliding of the first cam 1711 and the second cam 1712 toward or away from each other may be guided, and in addition, sliding of the first cam 1711 in the first direction and sliding of the second cam 1712 in the first direction may be linked, to further ensure that the first cam 1711 and the second cam 1712 can keep synchronous sliding in the first direction.

Further, one side that is of the first cam 1711 and that faces the second cam 1712 may further have a second protrusion 17115. Correspondingly, one side that is of the second cam 1712 and that faces the first cam 1711 may have a second recess 17125. The second protrusion 17115 may be slidably disposed in the second recess 17125. One side wall that is of the second protrusion 17115 and that faces the second fastening part 174 may abut against an inner wall of the second recess 17125. Similarly, fitted insertion of the second protrusion 17115 and the second recess 17125 may also guide the first cam 1711 and the second cam 1712 to slide toward or away from each other, and may provide assurance for synchronous sliding of the first cam 1711 and the second cam 1712 in the first direction, to further improve working reliability of the damping assembly 17.

In this embodiment of this application, a specific form of the elastic member 173 is not limited. For example, the elastic member 173 may be a spring 1731, or may be an elastic piece 1732. Certainly, ring to FIG. 14 and FIG. 15. A design form of using both the spring 1731 and the elastic piece 1732 may also be used. When this design is used, there may be a plurality of springs 1731 and a plurality of elastic pieces 1732. Two ends of each spring 1731 abut against the first fastening part 172 and the sliding part 175 respectively. The plurality of elastic pieces 1732 may be disposed, in a stacked manner, between the first fastening part 172 and the sliding part 175 in the first direction. A specific quantity of springs 1731 and elastic pieces 1732 may be set based on a magnitude of a damping force that needs to be provided by the damping assembly, space of the hinge mechanism, and the like. FIG. 14 and FIG. 15 show a case of two springs. In this case, the two springs 1731 may be disposed on two sides of the plurality of elastic pieces 1732, to ensure uniformity of a force applied to the sliding part, to help transmit a balanced damping force action to the first rotating arm 112 and the second rotating arm 120.

It may be understood that, to ensure that the elastic pieces 1732 can be reliably limited between the first fastening part 172 and the sliding part 175, during specific implementation, the plurality of elastic pieces 1732 may be sequentially sleeved on the guide rod 176, to avoid displacement of the elastic pieces 1732 when elastic deformation occurs, and improve the working reliability of the damping assembly 17.

Similarly, when the springs 1731 are limited between the first fastening part 172 and the sliding part 175, the damping assembly 17 may further include first pin shafts 177 that are in a one-to-one correspondence with the springs 1731. The first pin shafts 177 may sequentially penetrate the first fastening part 172, the sliding part 175, and the second fastening part 174 in the first direction. The springs 1731 are sleeved on the first pin shafts 177, to avoid a problem such as arching that occurs when the springs 1731 are elastically deformed. In this embodiment, a first clamping block 1721 may be disposed on one side that is of the first fastening part 172 and that is away from the sliding part 175. Clamping slots 17211 are disposed at positions that are of the first clamping block 1721 and that correspond to the first pin shafts 177. One end of each first pin shaft 177 may extend out of the first fastening part 172, and then may be clamped into the corresponding clamping slot 17211. Correspondingly, a second clamping block 1742 may be disposed on one side that is of the second fastening part 174 and that is away from the first fastening part 172. Clamping holes 17421 may be disposed at positions that are of the second clamping block 1742 and that correspond to the first pin shafts 177. The other end of each first pin shaft 177 may be clamped in the corresponding clamping hole 17421. In this way, the first pin shafts 177 may be relatively fastened to the base based on a clamping function of the first clamping block 1721 and the second clamping block 1742.

In addition, as described above, the first rotating arm 112 and the second rotating arm 120 may be rotatably connected to the base through a physical shaft, or may be rotatably connected to the base through a virtual shaft. When the first rotating arm 112 and the second rotating arm 120 are rotatably connected to the base through the physical shafts, the first pin shafts 177 may be used as the physical shafts connecting the first rotating arm 112 or the second rotating arm 120 to the base. In this case, the first pin shaft 177 on one side of the first rotating arm 112 may penetrate the first protruding part 1122 of the first rotating arm 112, and the first pin shaft 177 on one side of the second rotating arm 120 may penetrate the second protruding part 12002 of the second rotating arm. In this way, a rotating connection relationship between the first rotating arm 112 and the base and between the second rotating arm 120 and the base can be implemented.

In addition to the foregoing structure, in some embodiments of this application, the hinge mechanism may further have another possible structure. Refer to FIG. 14, FIG. 15, and FIG. 16 again, in this embodiment, the hinge mechanism may further include a synchronization assembly 18. The synchronization assembly 18 may include a first driving gear 181 disposed on one side that is of the first rotating arm 112 and that faces the second rotating arm 120, and a second driving gear 182 disposed on one side that is of the second rotating arm 120 and that faces the first rotating arm 112. The first driving gear 181 and the second driving gear 182 are in transmission connection. In this way, in a process in which one of the swing arms rotates around the base, the other swing arm may be driven to synchronously rotate around the base in a direction toward or away from each other, and rotation angles of the two swing arms may be consistent.

To improve movement stability of the synchronization assembly, the first driving gear 181 and the second driving gear 182 may each be sleeved on the first pin shaft 177 on the corresponding side. For example, in the first direction, the first driving gear 181 may be located on one side that is of the first protruding part 1122 and that is away from the first fastening part 172, and the first driving gear 181 and the first protruding part 1122 may be disposed at an interval. Similarly, the second driving gear 182 may also be located on one side that is of the second protruding part 12002 and that is away from the first fastening part 172, and the second driving gear 182 and the second protruding part 12002 are disposed at an interval. In this case, one side that is of the second fastening part 174 and that faces the first rotating arm 112 may be embedded between the first protruding part 1122 and the first driving gear 181, and one side that is of the second fastening part 174 and that faces the second rotating arm 120 may be embedded between the second protruding part 12002 and the second driving gear 182, to help improve mechanism compactness of the hinge mechanism.

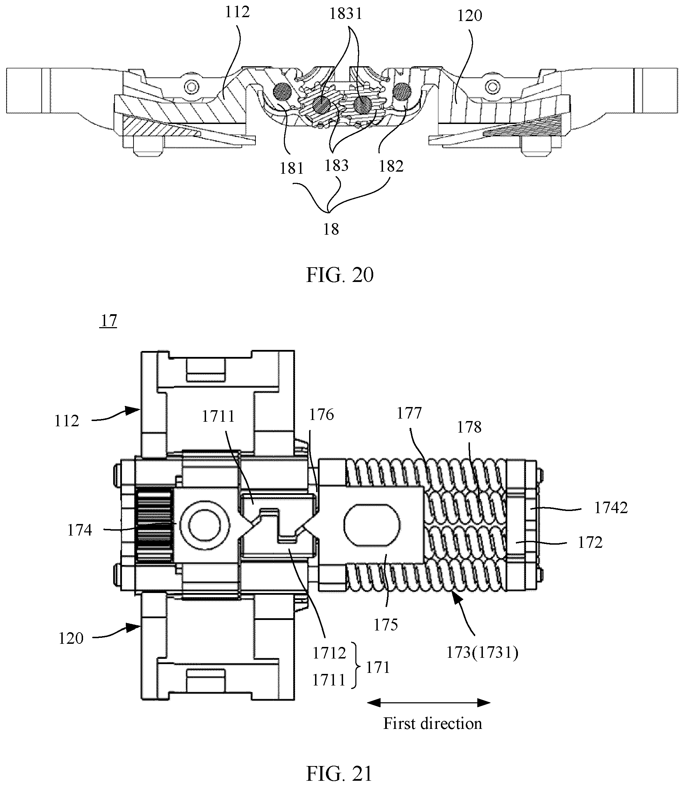

FIG. 20 is a diagram of a structure of a cross section of the hinge mechanism shown in FIG. 14 at B-B. In this embodiment of this application, the synchronization assembly 18 may further include driven gears 183. The driven gears 183 may be disposed between two driving gears. In addition, there may be an even quantity of driven gears 183. Adjacent driven gears 183 are engaged with each other, and the driven gears 183 and the driving gears that are adjacent are engaged with each other, so that the first driving gear 181 and the second driving gear 182 can rotate toward or away from each other through the even quantity of driven gears 183.

In addition, the synchronization assembly 18 may further include gear shafts 1831 that are in a one-to-one correspondence with the driven gears 183. In the first direction, two ends of each gear shaft 1831 may be fastened to the second fastening part 174 and the second clamping block 1742 respectively. Each driven gear 183 may be sleeved on the corresponding gear shaft 1831, to improve the movement stability of the synchronization assembly. Certainly, in some other implementations, the gear shafts 1831 may alternatively be rotatably connected to the second fastening part 174 and the second clamping block 1742 at two ends separately. In this case, each driven gear 183 may be fastened on the corresponding gear shaft 1831. In this implementation, each driven gear 183 and the corresponding gear shaft 1831 may be fastened in a key connection manner, or may be designed as an integrated structure. This is not specifically limited in this application.

It should be noted that, in this embodiment of this application, the synchronization assembly 18 may be accommodated in an accommodating space formed by the cover plate and the base, so that a structure of the hinge mechanism is compact. The synchronization assembly 18 is disposed, so that in a process in which one of the swing arms rotates around the base, the other swing arm may be driven to synchronously rotate around the base toward the direction toward or away from each other. In addition, because each swing arm may slide along the sliding slot of the housing fastening bracket on the corresponding side, in a process in which the swing arm rotates around the base, the housing fastening bracket on the same side may be driven to rotate by a same angle, so that in a process in which the two swing arms rotate synchronously, synchronous rotation of the two housing fastening brackets may be implemented. In addition, because the housing fastening brackets may be fastened to housings of the electronic device, the synchronous rotation of the two housing fastening brackets may drive the two housings of the electronic device to rotate synchronously. In this way, an instantaneous force may be prevented from being applied to the flexible display fastened to the two housings. This improves reliability of the flexible display.

FIG. 21 is a diagram of a partial structure of another hinge mechanism in an unfolded state according to an embodiment of this application. In this embodiment, the damping assembly 17 also includes the transmission member 171, the first fastening part 172, the elastic member 173, the second fastening part 174, and the sliding part 175. Structures and disposition manners of the transmission member 171, the first fastening part 172, and the second fastening part 174 may be roughly the same as those in the foregoing embodiment, and details about these components are not described herein again. Different from the foregoing embodiment, in this embodiment, the elastic member 173 may all be in a form of a spring 1731, and a specific quantity of springs 1731 may be set based on the magnitude of the damping force that needs to be provided by the damping assembly 17, the space of the hinge mechanism, and the like. This is not limited in this application. FIG. 17 shows a case in which the elastic member includes four springs 1731. Two ends of each spring 1731 abut against the first fastening part 172 and the sliding part 175 respectively.

For the two springs 1731 located on the two sides, the two springs 1731 may be sleeved on the foregoing two first pin shafts 177 respectively, to avoid a problem such as arching that occurs when the two springs are elastically deformed. In addition, the damping assembly 17 may further include two second pin shafts 178. The two second pin shafts 178 may be located between the two first pin shafts 177. The second pin shafts 178 may sequentially penetrate the first fastening part 172 and the sliding part 175 in the first direction. One end of each second pin shaft 178 may extend out of the first fastening part 172, and then may be clamped into the first clamping block 1721. The other end of each second pin shaft 178 may be slidably connected to the sliding part 175, to guide sliding of the sliding part 175 in the first direction. In this case, each of the two middle springs 1731 may be sleeved on the corresponding second pin shaft 178, so that deformation directions of the springs 1731 sleeved on the second pin shafts 178 are limited by using the second pin shafts 178.

Still refer to FIG. 21. In this embodiment, when the guide rod 176 is disposed, one end of the guide rod 176 may be fastened to the first fastening part 172, and the other end of the guide rod 176 may be slidably connected to the sliding part 175. In other words, in addition to being slidably connected to the first pin shafts 177 and the second pin shafts 178, the sliding part 175 may also be slidably assembled on the guide rod 176 at the same time. Because locations of the two middle second pin shafts 178 are opposite to that of the guide rod 176 in the first direction, one end that is of the sliding part 175 and that faces the first fastening part 172 may be slidably assembled on the guide rod 176, and one end that faces the second fastening part 174 may be slidably assembled on the two second pin shafts 178. It may be understood that, to prevent the sliding part 175 from sliding off from the second pin shafts 178 when sliding toward the second fastening part 174, or from sliding off from the guide rod 176 when sliding toward the first fastening part 172, during a specific design, a length of a middle area of the sliding part 175 in the first direction may be appropriately increased, to improve movement stability of the sliding part 175.

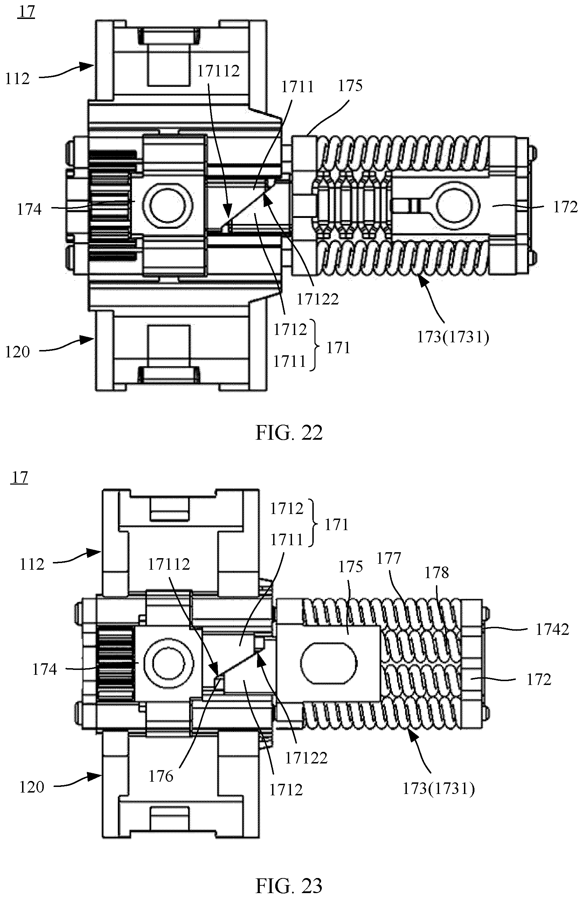

FIG. 22 is a diagram of a partial structure of another hinge mechanism in an unfolded state according to an embodiment of this application. In this embodiment, the damping assembly 17 may also include the transmission member 171, the first fastening part 172, the elastic member 173, the second fastening part 174, and the sliding part 175. Structures of the elastic member 173 and the first fastening part 172 may be set with reference to the embodiment shown in FIG. 14, and compared with those in the embodiment shown in FIG. 14, the structures of the transmission member 171, the sliding part 175, and the second fastening part 174 change. Specifically, one side that is of the second fastening part 174 and that faces the transmission member 171 no longer has the first bump, but the side has a planar structure. Similarly, one side that is of the sliding part 175 and that faces the transmission member may also be designed as a planar structure.

When the transmission member 171 is specifically disposed, one end that is of the first cam 1711 of the transmission member 171 and that faces the second fastening part 174 may abut against the second fastening part 174. One end that is of the second cam 1712 of the transmission member 171 and that faces the sliding part 175 may abut against the sliding part 175. In addition, the first inclined surface 17112 of the first cam 1711 and the second inclined surface 17122 of the second cam 1712 may be disposed in parallel and abut against each other. In this way, an inclined surface transmission pair may be formed between the first inclined surface 17112 and the second inclined surface 17122.

When the first rotating arm 112 and the second rotating arm 120 rotate in a direction of unfolding the electronic device, the first cam 1711 and the second cam 1712 are driven to slide toward each other. In this case, the second inclined surface 17122 of the second cam 1712 applies a component force in a direction toward the second fastening part 174 to the first cam 1711. Because the first cam 1711 abuts against the second fastening part 174, in a rotation process of the first rotating arm 112, the first cam 1711 has only displacement in a radial direction, and does not generate displacement in the first direction. On the contrary, the first inclined surface 17112 of the first cam 1711 applies a reacting force in a direction toward the first fastening part 172 to the second cam 1712. Driven by the reacting force, while the second cam 1712 slides toward the first cam 1711, displacement of sliding in a direction close to the first fastening part 172 is also generated. In other words, the actual movement trajectory of the second cam 1712 is sliding in the inclination direction of the first inclined surface 17112. In this way, the second cam 1712 may drive the sliding part 175 to synchronously slide toward one side close to the first fastening part 172, to compress the elastic member 173. The elastic force generated by the elastic member 173 may be transmitted to the second cam 1712 through the sliding part 175, and may continue to be transmitted to the first cam 1711 through the second cam 1712, so that the elastic force is separately transmitted to the swing arms on the two sides through the first cam 1711 and the second cam 1712.

When the first rotating arm 112 and the second rotating arm 120 move away from each other in the direction of folding the electronic device, the elastic member 173 gradually rebounds in the compressed state, releases the accumulated elastic potential energy, and pushes the second cam 1712 to slide in the direction close to the second fastening part 174. In this case, the first inclined surface 17112 of the first cam 1711 applies a component force in a direction toward the second rotating arm 120 to the second cam 1712, so that while the second cam 1712 slides in the direction close to the second fastening part 174, displacement of sliding in the direction toward the second rotating arm 120 is also generated. Therefore, the torque force action that helps the rotation of the second rotating arm 120 may be applied to the second rotating arm 120. On the contrary, the second inclined surface 17122 of the second cam 1712 applies a reacting force in a direction toward the first rotating arm 112 to the first cam 1711. Driven by the reacting force, the first cam 1711 also slides toward the direction close to the first rotating arm 112, so that the torque force action that helps the rotation of the first rotating arm 112 may be applied to the first rotating arm 112. It can be seen that, in this process, specific folding assistance may be provided for the hinge mechanism by using the elastic potential energy released by the elastic member 173, to reduce difficulty of unfolding and folding operations of the electronic device.

FIG. 23 is a diagram of a partial structure of another hinge mechanism in an unfolded state according to an embodiment of this application. In this embodiment, the damping assembly 17 may also include the transmission member 171, the first fastening part 172, the elastic member 173, the second fastening part 174, and the sliding part 175. Structures of the transmission member 171, the first fastening part 172, and the sliding part 175 may be set with reference to the embodiment shown in FIG. 20. A difference lies in that, in this embodiment, the elastic member 173 may all be in the form of the spring 1731, and the specific quantity of springs 1731 may be set based on the magnitude of the damping force that needs to be provided by the damping assembly 17, the space of the hinge mechanism, and the like. This is not limited in this application. FIG. 23 shows a case in which the elastic member 173 includes four springs 1731. Two ends of each spring 1731 abut against the first fastening part 172 and the sliding part 175 respectively.

When the elastic member 173 is specifically disposed, similar to the embodiment shown in FIG. 21, the two springs 1731 on the two sides may be sleeved on the two first pin shafts 177 respectively. For the two middle springs 1731, two second pin shafts 178 may be disposed between the two first pin shafts 177. The second pin shafts 178 may sequentially penetrate the first fastening part 172 and the sliding part 175 in the first direction. One end of each second pin shaft 178 may extend out of the first fastening part 172, and then may be clamped into the first clamping block 1721. The other end of each second pin shaft 178 may be slidably connected to the sliding part 175, to guide sliding of the sliding part 175 in the first direction. In this case, each of the two middle springs 1731 may be sleeved on the corresponding second pin shaft 178, so that deformation directions of the springs 1731 sleeved on the second pin shafts 178 are limited by using the second pin shafts 178.

In addition, because locations of the two middle second pin shafts 178 are opposite to that of the guide rod 176 in the first direction, one end that is of the sliding part 175 and that faces the first fastening part 172 may be slidably assembled on the guide rod 176, and one end that faces the second fastening part 174 may be slidably assembled on the two second pin shafts 178. To prevent the sliding part 175 from sliding off from the second pin shafts 178 when sliding toward the second fastening part 174, or from sliding off from the guide rod 176 when sliding toward the first fastening part 172, during a specific design, the length of the middle area of the sliding part 175 in the first direction may be appropriately increased, to improve the movement stability of the sliding part 175.

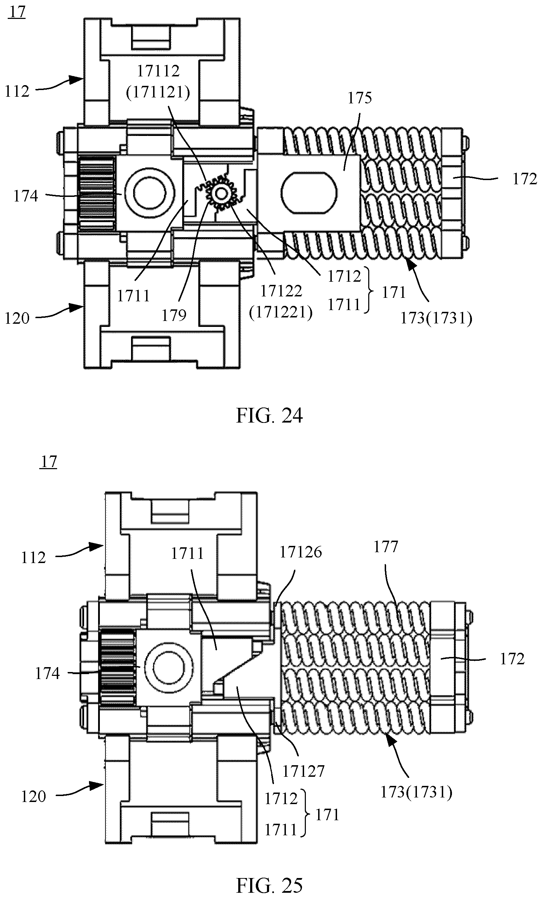

FIG. 24 is a diagram of a partial structure of another hinge mechanism in an unfolded state according to an embodiment of this application. In this embodiment, in addition to including structures such as the transmission member 171, the first fastening part 172, the elastic member 173, the second fastening part 174, and the sliding part 175, the damping assembly may further include an intermediate gear 179. During specific implementation, a first rack 171121 may be disposed on the first inclined surface 17112 of the first cam 1711. A second rack 171221 may be disposed on the second inclined surface 17122 of the second cam 1712. The intermediate gear 179 is disposed between the first inclined surface 17112 and the second inclined surface 17122, and the intermediate gear 179 is separately engaged with the first rack 171121 and the second rack 171221 on two sides. When the first cam 1711 and the second cam 1712 slide toward or away from each other, the two sides of the intermediate gear 179 roll on the first rack 171121 and the second rack 171221 respectively. In this way, synchronization of sliding of the first cam 1711 and the second cam 1712 toward or away from each other may be ensured, to further help improve the working reliability of the damping assembly 17.

In addition, structures of the first fastening part 172, the second fastening part 174, the sliding part 175, and the elastic member 173 in this embodiment may be set with reference to the embodiment shown in FIG. 23. Details are not described herein again.

FIG. 25 is a diagram of a partial structure of another hinge mechanism in an unfolded state according to an embodiment of this application. In this embodiment, the damping assembly 17 may include the transmission member 171, the first fastening part 172, the elastic member 173, and the second fastening part 174. The first fastening part 172, the second fastening part 174, and the elastic member 173 may be disposed with reference to the embodiment shown in FIG. 23. Different from the embodiment shown in FIG. 23, in this embodiment of this application, the sliding part is omitted. Therefore, one end that is of the second cam 1712 of the elastic member 173 and that faces the first fastening part 172 may elastically abut against the elastic member 173 directly. In other words, the elastic member 173 is limited between the second cam 1712 and the first fastening part 172. This design can simplify a structure of the damping assembly 17 to some extent. In this way, assembly difficulty of the hinge mechanism can be reduced, and in addition, costs of the hinge mechanism can be reduced.

It should be noted that, when the elastic member 173 includes a plurality of springs 1731, to reliably limit the springs 1731 disposed near edges, in this embodiment, a first extension part 17126 and a second extension part 17127 may be disposed at one end that is of the second cam 1712 and that faces the first fastening part 172. The first extension part 17126 may extend toward one side on which the first rotating arm 112 is located. The second extension part 17127 may extend toward one side on which the second rotating arm 120 is located. In addition, the first extension part 17126 and the second extension part 17127 may be respectively sleeved on the first pin shafts 177 on the two sides. In this way, the springs 1731 located on the two sides may be respectively limited between the first extension part 17126 and the first fastening part 172 and between the second extension part 17127 and the first fastening part 172.

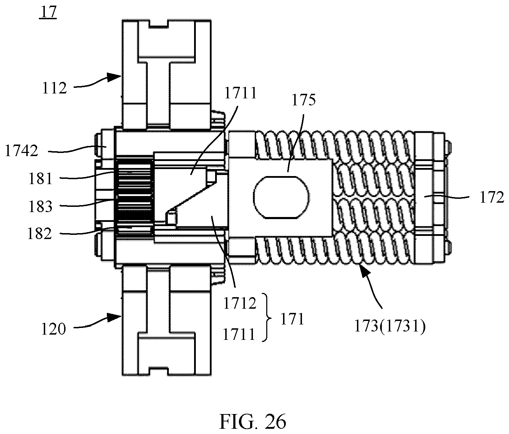

FIG. 26 is a diagram of a partial structure of another hinge mechanism in an unfolded state according to an embodiment of this application. In this embodiment, the damping assembly 17 may include the transmission member 171, the first fastening part 172, the elastic member 173, and the sliding part 175. The first fastening part 172, the sliding part 175, and the elastic member 173 may be disposed with reference to the embodiment shown in FIG. 23. Different from the embodiment shown in FIG. 23, in this embodiment of this application, the second fastening part is omitted. In this case, one end that is of the first cam 1711 and that is away from the first fastening part 172 may abut against an end face of the first driving gear 181, an end face of the second driving gear 182, and end faces of the two driven gears 183. This design may also simplify the structure of the damping assembly. This helps reduce assembly difficulty and costs of the hinge mechanism.

The inclined surface transmission pair formed by the first inclined surface of the first cam 1711 and the second inclined surface of the second cam 1712 is used, so that, in a process in which the first rotating arm 112 and the second rotating arm 120 rotate, the first cam 1711 may slide in the radial direction close to or away from the second cam 1712, and the second cam 1712 has both displacement in the radial direction and displacement in the first direction. Therefore, the second cam 1712 may push the sliding part 175 to slide toward one side of the first fastening part 172 while sliding in a direction close to the first cam 1711, to compress the elastic member 173; or the second cam 1712 may be pushed by the sliding part 175 to slide toward one side away from the first fastening part 172 when the elastic member 173 rebounds, and slide away from the first cam 1711 under the abutting between the first inclined surface and the second inclined surface abut, so that the torque force actions that help the rotation of the first rotating arm 112 and the second rotating arm 120 are applied to the first rotating arm 112 and the second rotating arm 120 through the first cam 1711 and the second cam 1712.

It should be noted that, in this embodiment, because the first cam 1711 has the displacement in the radial direction, when the two driven gears 183 are specifically disposed, one end of each gear shaft may be fastened or rotatably connected to the second clamping block 1742, and the other end of each gear shaft does not exceed an end face of the corresponding driven gear 183, to avoid interference with the first cam 1711. In addition, in some implementation solutions, a wear-resistant piece may be further disposed on an end face of each active gear and each driven gear 183, to reduce a friction loss caused by the first cam 1711 to each gear when the first cam 1711 slides, so that structural strength of the hinge mechanism can be improved.

It may be understood that, in some other embodiments, for the damping assembly 17, both the sliding part and the second fastening part may be omitted. In this case, one end that is of the first cam 1711 and that is away from the first fastening part 172 may abut against the end face of the first driving gear 181, the end face of the second driving gear 182, and the end faces of the two driven gears 183. One end that is of the second cam 1712 and that faces the first fastening part 172 directly abuts against the elastic member 173. This may further simplify the structure of the damping assembly 17, so that the assembly difficulty and costs of the hinge mechanism are reduced.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A hinge mechanism, comprising a base, a rotating assembly, and a damping assembly, wherein
the rotating assembly comprises a first rotating arm and a second rotating arm, the first rotating arm and the second rotating arm are rotatably connected to two sides of the base respectively, one side that is of the first rotating arm and that is close to the base has a first cam surface, and one side that is of the second rotating arm and that is close to the base has a second cam surface;
the damping assembly comprises a transmission member, a first fastening part, and an elastic member; the transmission member is slidably disposed on the base in a first direction, the transmission member is located between the first rotating arm and the second rotating arm, two sides of the transmission member abut against the first cam surface and the second cam surface respectively, and the transmission member is capable of sliding in the first direction when the first rotating arm and the second rotating arm rotate; the first fastening part is fastened on the base, and the first fastening part and the transmission member are disposed at an interval in the first direction; and the elastic member is elastically limited between the transmission member and the first fastening part; and
the first direction is an extension direction of rotation axes of the first rotating arm and the second rotating arm.

2. The hinge mechanism according to claim 1, wherein the transmission member comprises a first cam and a second cam; the first cam is located on one side close to the first rotating arm, one side of the first cam has a third cam surface abutting against the first cam surface, and the other side of the first cam has a first inclined surface; and the second cam is located on one side close to the second rotating arm, one side of the second cam has a third cam surface abutting against the second cam surface, and the other side of the second cam has a second inclined surface; and
the first cam and the second cam slide toward or away from each other with rotation of the first rotating arm and the second rotating arm, and the first inclined surface and the second inclined surface are in transmission connection, to push at least one of the first cam and the second cam to slide in the first direction.

3. The hinge mechanism according to claim 2, wherein the damping assembly further comprises a second fastening part, the second fastening part is fastened on the base, and the second fastening part abuts against one side that is of the transmission member and that is away from the first fastening part.

4. The hinge mechanism according to claim 2 or 3, wherein the damping assembly further comprises a sliding part, the sliding part is slidably disposed on the base in the first direction, and the sliding part abuts against one side that is of the transmission member and that faces the first fastening part; and
one end of the elastic member abuts against the first fastening part, and the other end of the elastic member abuts against the sliding part.

5. The hinge mechanism according to claim 3 or 4, wherein the first inclined surface is located at one end that is of the first cam and that is close to the second fastening part, and the second inclined surface is located at one end that is of the second cam and that is close to the second fastening part;
one side that is of the second fastening part and that faces the transmission member is provided with a first bump, one side that is of the first bump and that faces the first cam has a third inclined surface, and one side that is of the first bump and that faces the second cam has a fourth inclined surface; and
the first inclined surface and the third inclined surface are parallel and abut against each other, and the second inclined surface and the fourth inclined surface are parallel and abut against each other.

6. The hinge mechanism according to claim 5, wherein one side that is of the first cam and that faces the second cam has a first recess, one side that is of the second cam and that faces the first cam has a first protrusion, and the first protrusion is at least partially inserted into the first recess.

7. The hinge mechanism according to claim 5 or 6, wherein one side that is of the first cam and that faces the second cam has a second protrusion, one side that is of the second cam and that faces the first cam has a second recess, and the second protrusion is at least partially inserted into the second recess.

8. The hinge mechanism according to any one of claims 4 to 7, wherein one end that is of the first cam and that is close to the sliding part has a fifth inclined surface, and one end that is of the second cam and that is close to the sliding part has a sixth inclined surface;
one side that is of the sliding part and that faces the transmission member has a second bump, one side that is of the second bump and that faces the first cam has a seventh inclined surface, and one side that is of the second bump and that faces the second cam has an eighth inclined surface; and
the fifth inclined surface and the seventh inclined surface are parallel and abut against each other, and the sixth inclined surface and the eighth inclined surface are parallel and abut against each other.

9. The hinge mechanism according to any one of claims 4 to 7, wherein one side that is of the sliding part and that faces the transmission member is a plane.

10. The hinge mechanism according to claim 3 or 4, wherein one end that is of the first cam and that faces the second fastening part abuts against the second fastening part, and one end that is of the second cam and that faces the first fastening part abuts against the sliding part; and
the first inclined surface and the second inclined surface are parallel and abut against each other.

11. The hinge mechanism according to claim 3 or 4, wherein the first inclined surface and the second inclined surface are disposed in parallel, a first rack is disposed on the first inclined surface, and a second rack is disposed on the second inclined surface; and
the transmission member further comprises an intermediate gear, the intermediate gear is disposed between the first inclined surface and the second inclined surface, and the intermediate gear is separately engaged with the first rack and the second rack.

12. The hinge mechanism according to any one of claims 1 to 11, wherein the damping assembly further comprises a guide rod, the guide rod is fastened on the base, and the guide rod is disposed in the first direction; and
the transmission member is sleeved on the guide rod.

13. An electronic device, comprising a first housing, a second housing, a flexible display, and the hinge mechanism according to any one of claims 1 to 12, wherein
the first housing and the second housing are disposed on two opposite sides of the hinge mechanism respectively, the first rotating arm is slidably connected to the first housing, and the second rotating arm is slidably connected to the second housing; and
the flexible display continuously covers the first housing, the second housing, and the hinge mechanism, and the flexible display is fastened to the first housing and the second housing.
